(19) Europäisches Patentamt
European Patent Office
Office européen des brevets

(11) **EP 2 824 422 B1**

(12) **EUROPEAN PATENT SPECIFICATION**

(45) Date of publication and mention
of the grant of the patent:
**24.07.2019 Bulletin 2019/30**

(51) Int Cl.:
*G01C 19/5769* (2012.01)  *G01P 15/097* (2006.01)
*H01L 41/08* (2006.01)  *H01L 41/09* (2006.01)
*G01C 19/574* (2012.01)  *H01L 41/113* (2006.01)

(21) Application number: **13757487.7**

(22) Date of filing: **05.03.2013**

(86) International application number:
**PCT/JP2013/001349**

(87) International publication number:
**WO 2013/132830 (12.09.2013 Gazette 2013/37)**

(54) **INERTIAL FORCE SENSOR**

TRÄGHEITSKRAFTSENSOR

CAPTEUR DE FORCE D'INERTIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.03.2012 JP 2012052655
01.11.2012 JP 2012241565
01.11.2012 JP 2012241566**

(43) Date of publication of application:
**14.01.2015 Bulletin 2015/03**

(73) Proprietor: **Panasonic Intellectual Property
Management Co., Ltd.
Osaka-shi, Osaka 540-6207 (JP)**

(72) Inventors:
• **ISHIDA, Takami
2-1-61, Shiromi, Chuo-ku
Osaka, 540-6207 (JP)**
• **YAMAMOTO, Kensaku
2-1-61, Shiromi, Chuo-ku
Osaka, 540-6207 (JP)**

(74) Representative: **Grünecker Patent- und
Rechtsanwälte
PartG mbB
Leopoldstraße 4
80802 München (DE)**

(56) References cited:
EP-A1- 1 182 711  WO-A1-2009/041502
WO-A1-2011/093077  WO-A1-2011/093077
JP-A- 2004 069 435  JP-A- 2007 240 540
JP-A- 2008 026 018  JP-A- 2010 147 285
JP-A- 2010 192 585  JP-A- 2011 259 120
US-A1- 2011 271 757

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to an inertial force sensor to detect an inertial force used in various electronic devices for posture control and navigation for example of a movable body, such as an airplane, an automobile, a robot, a ship, and a vehicle.

BACKGROUND ART

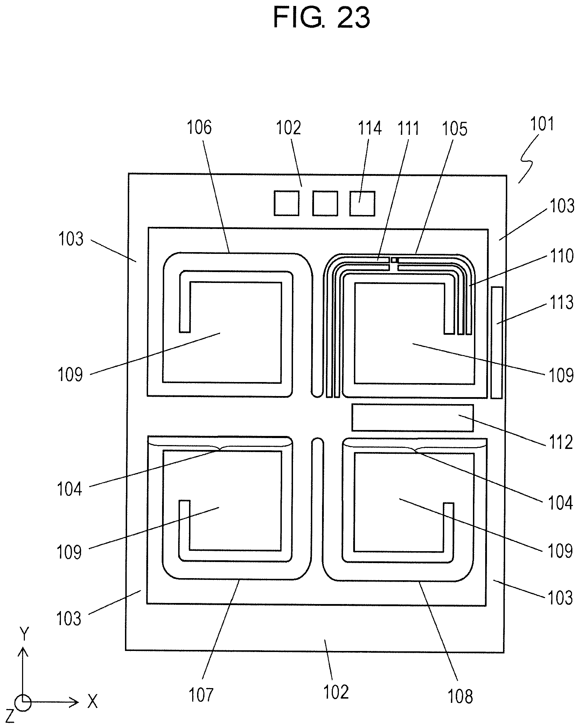

FIG. 23 is a plan view of a conventional inertial force sensor 101. Inertial force sensor 101 includes base 102, longitudinal beam section 103 supported by base 102, lateral beam section 104 supported by longitudinal beam section 103, arms 105, 106, 107, and 108 supported by lateral beam section 104, plummets 109 connected to arms 105, 106, 107, and 108, driving section 110 for driving arms 105, 106, 107, and 108, detection sections 111, 112, and 113 for detecting displacement of arms 105, 106, 107, and 108, wirings extending from driving section 110 and detection sections 111, 112, and 113, and connection electrodes 114 electrically connected via wirings to driving section 110 and detection sections 111, 112, and 113.

Lateral beam section 104 extends in a direction of an X-axis out of the X-axis, a Y-axis, and a Z-axis perpendicular to one another. One end of each of arms 105, 106, 107, and 108 is supported by lateral beam section 104 and extends in Y-axis direction. Driving section 110 drives arms 105, 106, 107, and 108 along an XY-plane. Detection sections 111, 112, and 113 detect the displacement of arms 105, 106, 107, and 108 in a direction of the X-axis, the Y-axis or the Z-axis.

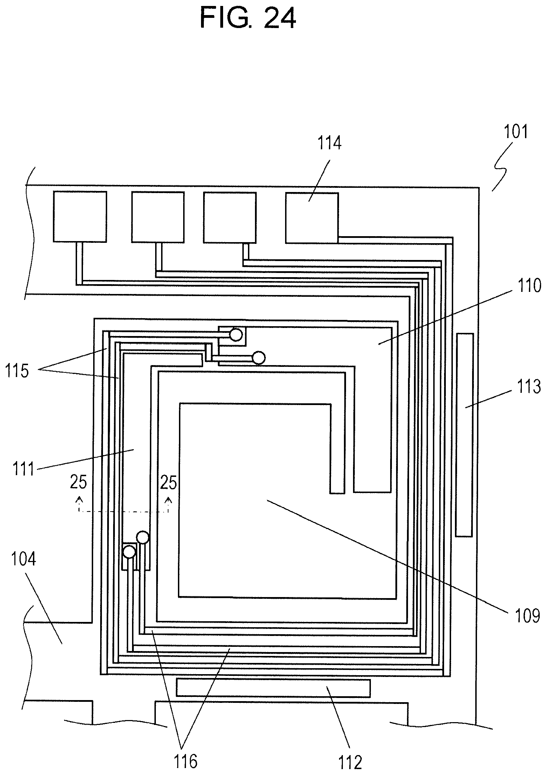

FIG. 24 is an expanded view of arm 105 of inertial force sensor 101 shown in FIG. 23. Wiring 115 extending from driving section 110 is provided on arm 105 together with detection section 111 on arm 105, and is provided on lateral beam section 104 together with detection section 112. Wiring 116 extending from detection section 111 is provided on lateral beam section 104 together with detection section 112. Each of the wirings on arms 106, 107, and 108 has the same configuration as the wiring on arm 105.

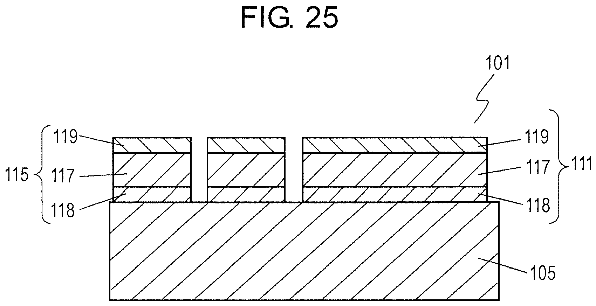

FIG. 25 is a cross-sectional view of arm 105 of inertial force sensor 101 at line 25-25 shown in FIG. 24. In inertial force sensor 101, wiring 115 has a layered structure including upper electrode layer 119, piezoelectric layer 117, and lower electrode layer 118.

A conventional inertial force sensor similar to inertial force sensor 101 is disclosed in, e.g. PTL 1.

WO 2009/041502 A1 relates to an angular velocity detecting device wherein the wiring of the driving and sensing electrodes is guided over an insulating layer covering the driving and the sensing electrodes.

CITATION LIST

PATENT LITERATURE

PTL1: International Publication No.2011/093077

SUMMARY

An inertial force sensor according to the present invention is defined in claim 1.

This inertial force sensor can have high sensitivity and a small size.

BRIEF DESCRIPTION OF THE DRAWINGS

FIG. 1 is a plan view of an inertial force senor according to Illustrative Embodiment 1 not part of the invention.

FIG. 2 is an expanded plan view of the inertial force sensor according to the illustrative Embodiment 1.

FIG. 3 is a cross-sectional view of the inertial force sensor at line 3-3 shown in FIG. 2.

FIG. 4 illustrates temperature characteristics of the inertial force sensor according to the illustrative Embodiment 1.

FIG. 5 illustrates temperature characteristics of the inertial force sensor according to the illustrative Embodiment 1.

FIG. 6 is a cross-sectional view of another inertial force sensor according to the illustrative Embodiment 1.

FIG. 7A is a cross-sectional view of the inertial force sensor at line 7A-7A shown in FIG. 2.

FIG. 7B is a cross-sectional view of a still another inertial force sensor according to the illustrative Embodiment 1.

FIG. 8A is a cross-sectional view of a further inertial force sensor according to the illustrative Embodiment 1.

FIG. 8B is a cross-sectional view of a further inertial force sensor according to the illustrative Embodiment 1.

FIG. 8C is a cross-sectional view of a further inertial force sensor according to the illustrative Embodiment 1.

FIG. 9 is a cross-sectional view of the inertial force sensor at line 9-9 shown in FIG. 2.

FIG. 10A is a cross-sectional view of the inertial force sensor at line 10A-10A shown in FIG. 2.

FIG. 10B is a cross-sectional view of a further inertial force sensor according to the illustrative Embodiment 1.

FIG. 10C is a cross-sectional view of a further inertial force sensor according to the illustrative Embodiment 1.

FIG. 11 is a plan view of a further inertial force sensor according to the illustrative Embodiment 1.

FIG. 12A is a schematic view of the inertial force sensor according to the illustrative Embodiment 1 for illustrating an operation of the inertial force sensor.

FIG. 12B is a schematic view of the inertial force sensor according to the illustrative Embodiment 1 for illustrating an operation of the inertial force sensor.

FIG. 13A illustrates a process for manufacturing the inertial force sensor according to the illustrative Embodiment 1.

FIG. 13B illustrates a process for manufacturing the inertial force sensor of Comparative Example 1.

FIG. 14A is a plan view of the inertial force sensor according to the illustrative Embodiment 1 for illustrating a process for manufacturing the inertial force sensor.

FIG. 14B is a plan view of the inertial force sensor according to the illustrative Embodiment 1 for illustrating a process for manufacturing the inertial force sensor.

FIG. 14C is a plan view of the inertial force sensor according to the illustrative Embodiment 1 for illustrating a process for manufacturing the inertial force sensor.

FIG. 14D is a plan view of the inertial force sensor according to the illustrative Embodiment 1 for illustrating a process for manufacturing the inertial force sensor.

FIG. 14E is a plan view of the inertial force sensor according to the illustrative Embodiment 1 for illustrating a process for manufacturing the inertial force sensor.

FIG. 14F is a plan view of the inertial force sensor according to the illustrative Embodiment 1 for illustrating a process for manufacturing the inertial force sensor.

FIG. 15 is a plan view of a further inertial force sensor according to the illustrative Embodiment 1.

FIG. 16A is a plan view of a further inertial force sensor according to the illustrative Embodiment 1.

FIG. 16B is a plan view of a further inertial force sensor according to the illustrative Embodiment 1.

FIG. 17 is a plan view of an inertial force sensor according to the illustrative Exemplary Embodiment 2 not part of the invention.

FIG. 18A is a plan view of an inertial force sensor according to Exemplary Embodiment 3.

FIG. 18B is a cross-sectional view of the inertial force sensor at line 18B-18B shown in FIG. 18A.

FIG. 19 is a cross-sectional view of the inertial force sensor at line 19-19 shown in FIG. 18A.

FIG. 20 is a cross-sectional view of the inertial force sensor at line 20-20 shown in FIG. 18A.

FIG. 21A illustrates a process for manufacturing the inertial force sensor according to Embodiment 3.

FIG. 21B illustrates a process for manufacturing an inertial force sensor of Comparative Example 2.

FIG. 22 is a plan view of an inertial force sensor according to Exemplary Embodiment 4.

FIG. 23 is a plan view of a conventional inertial force sensor.

FIG. 24 is a plan view of an arm of the conventional inertial force sensor.

FIG. 25 is a cross-sectional view of the arm of the inertial force sensor at line 25-25 shown in FIG. 24.

DETAIL DESCRIPTION OF PREFERRED EMBODIMENTS

Illustrative Embodiment 1 not part of the invention but facilitates understanding of the invention.

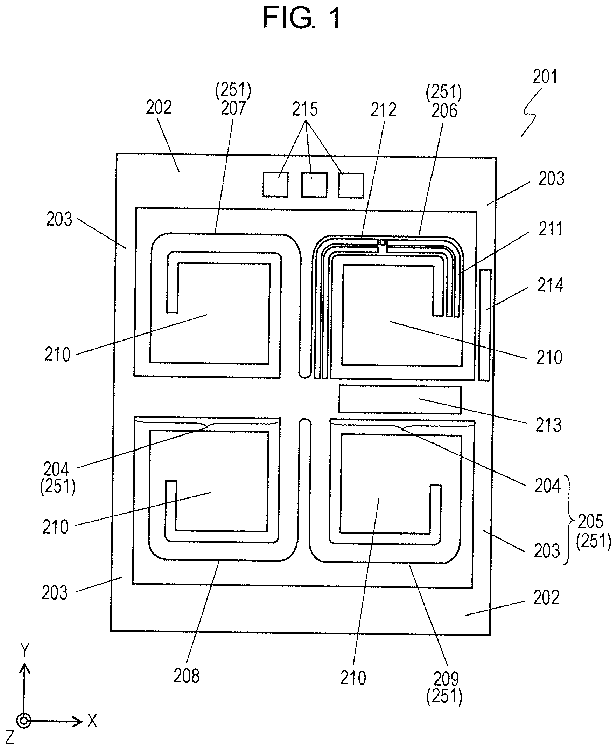

FIG. 1 is a plan view illustrating inertial force sensor 201 according to this Embodiment 1. Inertial force sensor 201 is an inertial force sensor that detects an angular velocity. In FIG. 1, an X-axis, a Y-axis, and a Z-axis perpendicular to one another are defined. An XY-plane including the X-axis and the Y-axis is defined. Inertial force sensor 201 includes base 202, beam section 205 connected to base 202, arms 206, 207, 208, and 209 having one ends supported by beam section 205, plummets 210 connected to arms 206, 207, 208, and 209, respectively, driving section 211 provided on portions arms 206, 207, 208, and 209 close to plummets 210, detection section 212 provided on beam section 205 of arm 206 (base 202), detection section 213 provided on beam section 205, detection section 214 provided on beam section 205, connection electrodes 215 electrically connected to driving section 211 and detection sections 212, 213, and 214. Driving section 211 drives and vibrates arms 206, 207, 208, and 209 in directions parallel to the XY-plane. Detection section 212 detects an inertial force produced due to an angular velocity about the Z-axis applied to inertial force sensor 201. Detection section 213 detects an inertial force produced due to an angular velocity about the Y-axis applied to inertial force sensor 201. Detection section 214 detects an inertial force produced due to an angular velocity about the X-axis applied to inertial force sensor 201. Inertial force sensor 201 further includes an interlayer insulating layer covering at least a part of driving section 211 and detection sections 212, 213, and 214, and wirings extending from driving section 211 and detection sections 212, 213, and 214, respectively. These wirings are provided on the interlayer insulating layer. Connection electrodes 215 are electrically connected via these wirings to driving section 211 and detection sections 212, 213, and 214, respectively. Beam section 205 and arms 206 to 209 constitute flexible section 251 that can warp.

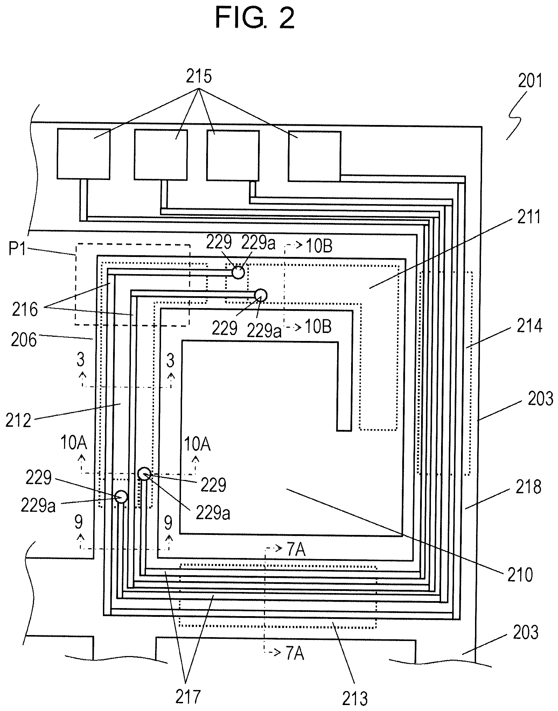

FIG. 2 is an expanded plan view of arm 206 of inertial force sensor 201. The wirings include wiring 216 extending from driving section 211 and wiring 217 extending from detection section 212.

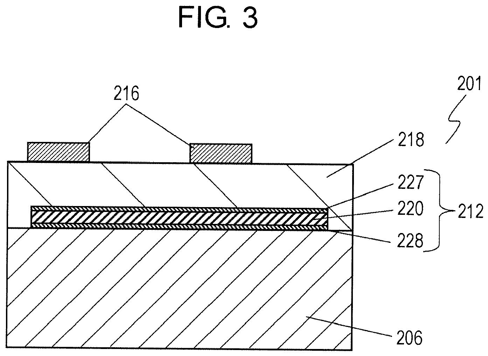

FIG. 3 is a cross-sectional view of inertial force sensor 201 at line 3-3 shown in FIG. 2 and illustrating a cross section of arm 206. Detection section 212 is provided on an upper surface of arm 206. Interlayer insulating layer 218 is provided on an upper surface of detection section 212. Driving wiring 216 is provided is provided on the upper surface of interlayer insulating layer 218. In this configuration, driving wiring 216 is provided on interlayer insulating layer 218 can provide detection sections 212, 213, and 214 with larger areas than an inertial force sensor in which driving wiring 216 and the detection section are arranged on the same surfaces, i.e., the upper surface of arm 206 and the upper surface of beam section 205, hence providing inertial force sensor 201 with high sensitivity. Diving section 211 and detection sections 212, 213, and 214 can have a large area ratio on arm 206 and beam section 205, thus providing inertial force sensor 201 with a small size. Further, the wirings on interlayer insulating layer 218 having a low relative permittivity reduce capacitances of the wirings. This structure can suppress unnecessary signals caused by the wiring, thereby improving an S/N ratio of inertial force sensor 201. Furthermore, the reduced wiring capacitances can reduce a noise level of inertial force sensor 201 to an acceptable level, which will be detailed.

Each of driving section 211 and detection sections 212, 213, and 214 includes lower electrode layer 228 provided on the upper surface of flexible section 251 (beam section 205 or arm 206), piezoelectric layer 220 provided on an upper surface of lower electrode layer 228, and upper electrode layer 227 provided on an upper surface of piezoelectric layer 220. An upper surface of upper electrode layer 227 constitutes the upper surfaces of driving section 211 as well as detection sections 212, 213, and 214. The larger area driving section 211 as well as detection sections 212, 213, and 214 have, a piezoelectric effect and an inverse piezoelectric effect can be more effectively used. Thus, inertial force sensor 201 can have improved driving efficiency and/or detection sensitivity.

Lower electrode layer 228 is made of, for example, a single metal consisting of at least one of copper, silver, gold, titanium, tungsten, platinum, chromium, or molybdenum or an alloy mainly containing these metals, or a layered configuration of these metals. Lower electrode layer 228 is preferably made of platinum (Pt) including Ti or TiOx to provide high conductivity and high stability in high-temperature oxidation atmosphere. Another layer, such as an orientation control layer consisting of titanate ($PbTiO_3$) may be provided on the upper surface of lower electrode layer 228. According to Embodiment 1, lower electrode layer 228 has a thickness ranging from 100 nm to 500 nm.

Piezoelectric layer 220 is made of piezoelectric material, such as zinc oxide, lithium tantalate, lithium niobate, or potassium niobate. Piezoelectric layer 220 is preferably made of lead zirconate titanate ($Pb(Zr,Ti)O_3$) to provide inertial force sensor 201 with a superior piezoelectric characteristic. Another layer, such as an adhesive layer made of titanium (Ti) may be provided on the upper surface of piezoelectric layer 220.

Upper electrode layer 227 is made of, for example, a single metal consisting of at least one of copper, silver, gold, titanium, tungsten, platinum, chromium, or molybdenum or an alloy mainly containing these metals, or a layered configuration of these metals. Upper electrode layer 227 is preferably made of gold (Au) to provide high resistance against most chemical corrosion, such as heat, moisture or oxygen. According to Embodiment 1, upper electrode layer 227 has a thickness ranging from 100 nm to 2000 nm.

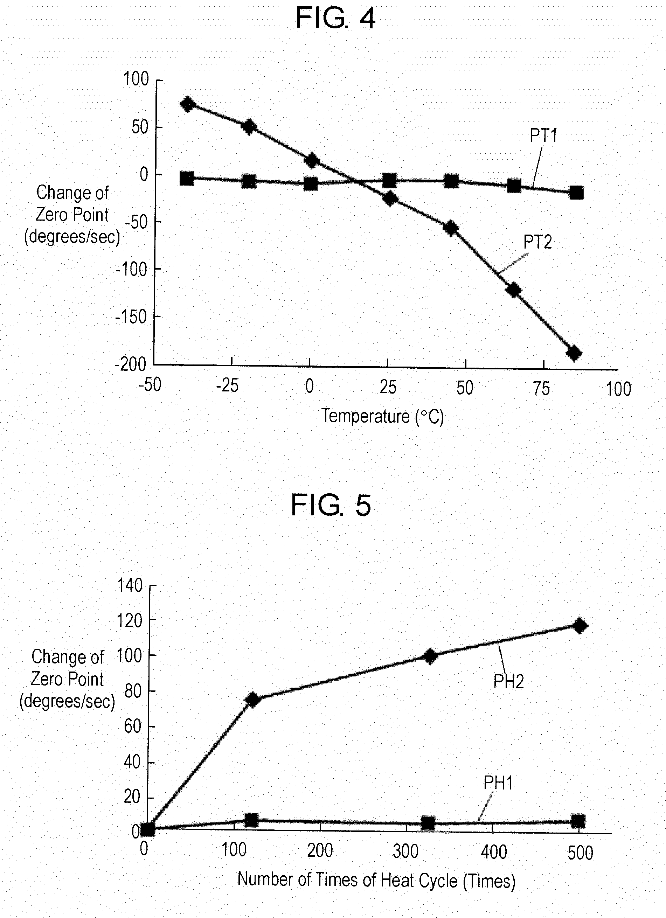

FIG. 4 is a characteristic diagram illustrating temperature profile PT1 of inertial force sensor 201 and temperature profile PT2 of conventional inertial force sensor 101. In FIG. 4, the horizontal axis represents an ambient temperature of the inertial force sensor, and the vertical axis represents a variation of a zero point of an output from the inertial force sensor having no inertial force (angular velocity) applied thereto, i.e., the inertial force sensor remaining stationary. The output from the inertial force sensor in the stationary condition was measured when the ambient temperature was changed from -40 °C to 80 °C.

As shown in FIG. 4, conventional inertial force sensor 101 exhibits temperature profile PT2 in which the zero point of the output from inertial force sensor 101 significantly changes depending on a change of the ambient temperature. On the other hand, inertial force sensor 201 according to Embodiment 1 exhibits temperature profile PT1 in which the change of the zero point of the output is significantly suppressed. This is caused for a reason that interlayer insulating layer 218 reduces a capacitive coupling between driving wiring 216 and the detection section. Specifically, in the case of the conventional wiring structure, piezoelectric layer 117 having a high relative permittivity causes a large capacitive coupling between wiring 115 and the detection section. The capacitive coupling between the driving section and the detection section changes in response to a temperature change, hence increasing the change of the zero point. On the other hand, in inertial force sensor 201, the wiring provided on interlayer insulating layer 218 reduces a capacitive coupling between driving wiring 216 and the detection section. The change of the capacitive coupling in response to a temperature change is reduced accordingly. Thus, the change of the zero point of the output is suppressed significantly.

FIG. 5 is a characteristic diagram illustrating thermal fatigue profile PHI of inertial force sensor 201 and thermal fatigue profile PH2 of conventional inertial force sensor 101. In FIG. 5, the horizontal axis represents the number of the times of the heat cycle applied to the inertial force sensor and the vertical axis represents a change of the zero point of the output of the inertial force sensor having no inertial force (angular velocity) is applied thereto, i.e., the inertial force sensor remaining stationary. The inertial force sensor is subjected to heat cycles at a temperature range from -40 °C to 150 °C repetitively plural times. The relation between the number of the times of the heat cycle and the output from the inertial force sensor 201 remaining stationary was measured.

As shown in FIG. 5, conventional inertial force sensor 101 exhibits a change in the zero point of the output depending on an increase of the number of times of the heat cycle. On the other hand, inertial force sensor 201 according to Embodiment 1 exhibits a change of the zero point of the output is significantly suppressed even after being subjected the heat cycles. This is for a reason that interlayer insulating layer 218 can reduce a change of a capacitive coupling. Specifically, in the conventional wiring structure, the characteristic of piezoelectric layer 117 changes due to an influence of the heat cycle, accordingly changing the capacitive coupling. This may causes a change of the zero point after the heat cycles. On the other hand, in inertial force sensor 201, even when the characteristic of interlayer insulating layer 218 changes due to the influence of the heat cycles, the capacitive coupling may not change since the interlayer insulating layer has a permittivity capacitive coupling smaller than that of the piezoelectric material. This suppresses a change of the zero point of the output after the heat cycles.

In inertial force sensor 201, wirings 216 and 217 are provided above detection section 212 via interlayer insulating layer 218. Thus, driving section 211 and detection section 212 can have large strength, and provides inertial force sensor 201 with high reliability accordingly. More specifically, in conventional inertial force sensor 101, the stress caused by the vibration of arm 206 may cause a defect such as crack or hillock in driving section 211 and detection section 212, thus reducing reliability of the sensor. However, in inertial force sensor 201, interlayer insulating layer 218 and wirings 216 and 217 protect driving section 211 and detection section 212, and provide driving section 211 and detection section 212 with high reliability, thus providing inertial force sensor 201 with high reliability. This configuration is particularly effective for a part, such as region P1 shown in FIG. 2, having a stress concentrating thereto.

Driving wiring 216 and detection wiring 217 extend from upper electrode layer 227 and lower electrode layer 228 to utilize a piezoelectric effect and an inverse piezoelectric effect of piezoelectric layer 220. However, driving wiring 216 and detection wiring 217 can share lower electrode layer 228 in a possible range.

Paths to dispose wirings 216 and 217 on the upper surface of interlayer insulating layer 218 is preferably arranged to cancel the capacitive coupling between wirings 216 and 217. An example will be described below.

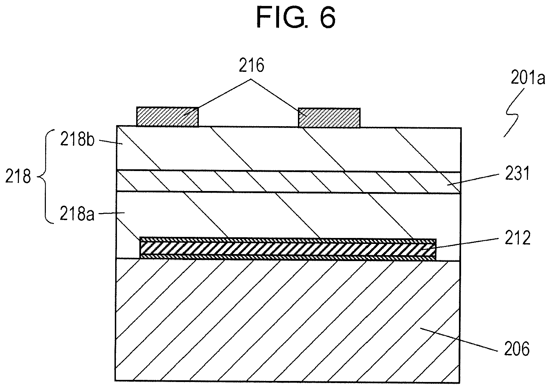

FIG. 6 is a cross-sectional view of another inertial force sensor 201a according to Embodiment 1. In FIG. 6, components identical to those of inertial force sensor 201 shown in FIGs. 1 to 3 are denoted by the same reference numerals.

Inertial force sensor 201a shown in FIG. 6 further includes metal layer 231 (a grounding layer) provided in interlayer insulating layer 218. More specifically, interlayer insulating layer 218 includes interlayer insulating layers 218a and 218b. Inertial force sensor 201a includes interlayer insulating layer 218a provided on an upper surface of detection section 212, metal layer 231 provided on an upper surface of interlayer insulating layer 218a, and interlayer insulating layer 218b provided on an upper surface of metal layer 231. Driving wiring 216 is provided on an upper surface of interlayer insulating layer 218b. Metal layer 231 is connected to a reference potential, such as a grounding potential, via a wiring.

Inertial force sensor 201a shown in FIG. 6 can provide the effect of inertial force sensor 201 shown in FIG. 3, and cancel the capacitive coupling between the wirings, hence having an S/N ratio improved.

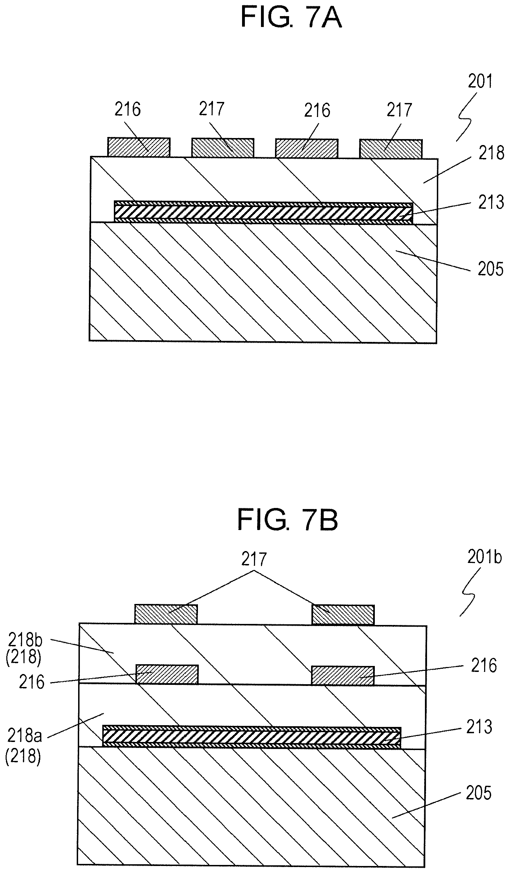

FIG. 7A is a cross-sectional view of inertial force sensor 201 at line 7A-7A shown in FIG. 2. Driving wiring 216 and detection wiring 217 are provided on the upper surface of interlayer insulating layer 218. Driving wiring 216 and detection wiring 217 are alternately arranged. Specifically, wirings in which signals having opposite phases to each other flow are arranged alternately. This configuration can provide the effect described in FIG. 3 and allow the inertial force sensor to have an S/N ratio further improved. This is because the capacitive coupling between the wirings can be cancelled.

FIG. 7B is a cross-sectional view of still another inertial force sensor 201b according to Embodiment 1. In FIG. 7B, components identical to those of inertial force sensor 201 shown in FIGs. 1 to 3 and 7A are denoted by the same reference numerals. In inertial force sensor 201b shown in FIG. 7B, interlayer insulating layer 218 includes interlayer insulating layer 218a provided on an upper surface of detection section 213, and interlayer insulating layer 218b provided on an upper surface of interlayer insulating layer 218a. Driving wiring 216 is provided on the upper surface of interlayer insulating layer 218a. Interlayer insulating layer 218b is provided on the upper surface of driving wiring 216. Detection wiring 217 is provided on an upper surface of interlayer insulating layer 218b. This configuration can provide the effect obtained by inertial force sensor 201 shown in FIG. 7A and provide a small capacitive coupling. This is because inertial force sensor 201b shown in FIG. 7B can provide a larger distance between driving wiring 216 and detection wiring 217 than inertial force sensor 201 shown in FIG. 7A,.

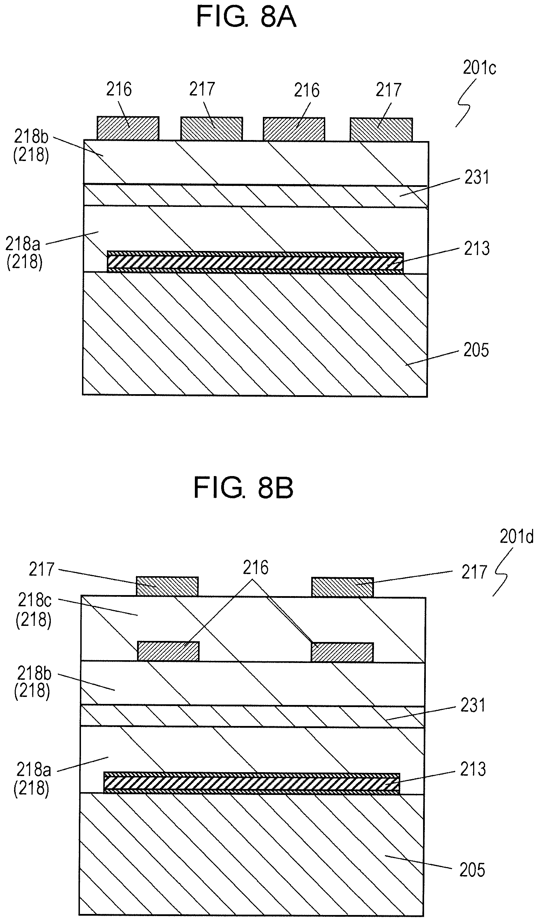

FIG. 8A is a cross-sectional view of further inertial force sensor 201c according to Embodiment 1. In FIG. 8A, components identical to those of inertial force sensor 201 shown in FIGs. 1 to 3 and 7A are denoted by the same reference numerals. Inertial force sensor 201c further includes metal layer 231 (a grounding layer) provided in interlayer insulating layer 218. More specifically, interlayer insulating layer 218 includes interlayer insulating layer 218a provided on an upper surface of detection section 213 and interlayer insulating layer 218b provided on an upper surface of metal layer 231. Metal layer 231 is provided on an upper surface of interlayer insulating layer 218a. Driving wiring 216 and detection wiring 217 are provided on the upper surface of interlayer insulating layer 218b. Metal layer 231 is connected to a reference potential, such as a grounding potential, via a wiring.

Inertial force sensor 201c not provide the effect obtained by inertial force sensor 201 shown in FIG. 7A and provide a small capacitive coupling. This is due to that metal layer 231 reduces the capacitive coupling between detection section 213 and each of detection wiring 217 and driving wiring 216.

FIG. 8B is a cross-sectional view of further inertial force sensor 201d according to Embodiment 1. In FIG. 8B, components identical to those of inertial force sensor 201 shown in FIGs. 1 to 3 and 7A are denoted by the same reference numerals. Inertial force sensor 201d further includes metal layer 231 (a grounding layer) provided in interlayer insulating layer 218. More specifically, interlayer insulating layer 218 includes interlayer insulating layer 218a provided on an upper surface of detection section 213, interlayer insulating layer 218b provided on an upper surface of metal layer 231, and interlayer insulating layer 218c provided on an upper surface of interlayer insulating layer 218b. Metal layer 231 is provided on the upper surface of interlayer insulating layer 218a. Driving wiring 216 is provided on the upper surface of interlayer insulating layer 218b. Interlayer insulating layer 218c is provided on the upper surface of driving wiring 216. Detection wiring 217 is provided on an upper surface of interlayer insulating layer 218c. Metal layer 231 is connected to a reference potential, such as a grounding potential, via a wiring.

Inertial force sensor 201d can provide the effect of inertial force sensor 201a shown in FIG. 7B and provide a small capacitive coupling between detection section 213 and each of detection wiring 217 and driving wiring 216.

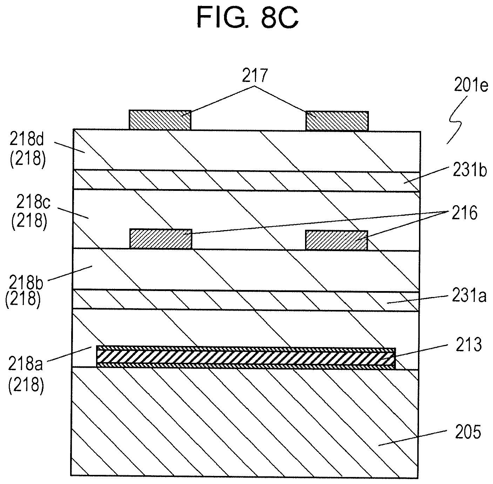

FIG. 8C is a cross-sectional view of further inertial force sensor 201e according to Embodiment 1. In FIG. 8C, components identical to those of inertial force sensor 201 shown in FIGs. 1 to 3 and 7A are denoted by the same reference numerals. Inertial force sensor 201e further includes metal layers 231a and 231b (a grounding layer) provided in interlayer insulating layer 218. More specifically, interlayer insulating layer 218 includes interlayer insulating layer 218a provided on an upper surface of detection section 213, interlayer insulating layer 218b provided on an upper surface of metal layer 231a, interlayer insulating layer 218c provided on an upper surface of interlayer insulating layer 218b, and interlayer insulating layer 218d provided on an upper surface of metal layer 231b. Metal layer 231a is provided on an upper surface of interlayer insulating layer 218a. Driving wiring 216 is provided on the upper surface of interlayer insulating layer 218b. Interlayer insulating layer 218c is provided on the upper surface of driving wiring 216. Metal layer 231b is provided on an upper surface of interlayer insulating layer 218c. Detection wiring 217 is provided on the upper surface of interlayer insulating layer 218d. At least one of metal layers 231a and 231b is connected to a reference potential, such as a grounding potential, via a wiring.

In inertial force sensors 201b and 201d shown in FIGs. 7B and 8B, detection wiring 217 is provided above driving wiring 216. Detection wiring 217 may be replaced with driving wiring 216 to place driving wiring 216 above detection wiring 217. Detection wiring 217 provided above driving wiring 216 can provide a small capacitance. This is because detection wiring 217 is exposed to air or vacuum having a lower permittivity than interlayer insulating layer 218, thus reducing the capacitive coupling.

Piezoelectric layer 220 may not preferably be provided on a portion of base 202 having connection electrode 215 thereon or on a portion of the upper surface of flexible section 251 (arm 206 and beam section 205) having detection section 212 or driving section 211 not provided thereon. Specifically, interlayer insulating layer 218 is preferably provided on the upper surface of base 202 or flexible section 251 (arm 206, beam section 205). Wirings 216 and 217 are provided on the upper surface of interlayer insulating layer 218. In this configuration, wirings 216 and 217 and connection electrode 215 do not extend above piezoelectric layer 220, and hence, can suppress an unnecessary signal component (noise) caused in the wirings of inertial force sensor 201 and connection electrode 215, accordingly improving sensitivity of inertial force sensor 201.

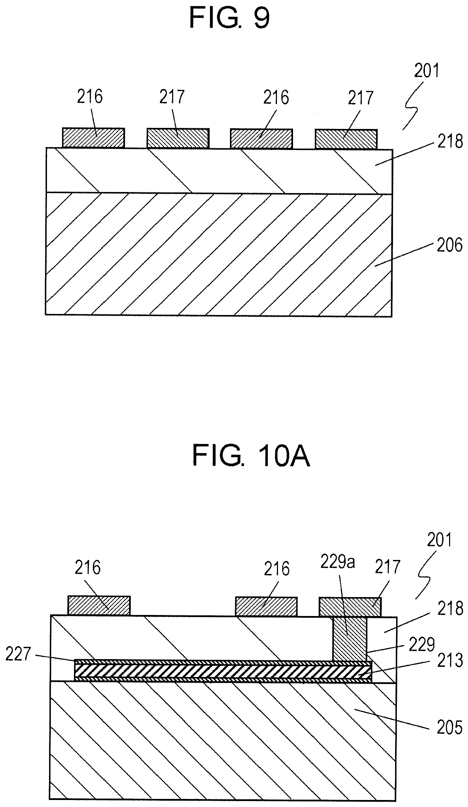

FIG. 9 is a cross-sectional view of inertial force sensor 201 at line 9-9 shown in FIG. 2. Interlayer insulating layer 218 is provided on an upper surface of arm 206. Wirings 216 and 217 are provided on an upper surface of interlayer insulating layer 218. In this configuration, wiring 216 and 217 do not extend above piezoelectric layer. This can consequently suppress the unnecessary signal component (noise) caused by the vibration leakage during the driving of inertial force sensor 201, hence providing inertial force sensor 201 with high sensitivity.

Detection wiring 217 functioning as a wiring of detection section 212 extends on interlayer insulating layer 218 provided on detection section 213 and detection section 214. This configuration provides detection section 213 and detection section 214 with larger areas than an inertial force sensor in which detection section 212 and each detection section are arranged on longitudinal beam section 203 and lateral beam section 204, hence providing inertial force sensor 201 with high sensitivity. Driving section 211 and detection sections 212, 213, and 214 provided on arm 206 and beam section 205 have large area ratios, thus providing inertial force sensor 201 with a small size.

The wirings extending from detection section 213 and detection section 214 can be arranged similarly to detection section 212. Thus, each detection section can have a large area, thus accordingly providing inertial force sensor 201 with high sensitivity. Driving section 211 and detection sections 212, 213, and 214 provided on arm 206 and beam section 205 can have large area ratio, hence providing inertial force sensor 201 with a small size.

Constituting elements of the inertial force sensor will be described below.

Beam section 205 includes a pair of longitudinal beam sections 203 supported by base 202 in a direction parallel to the Y-axis and lateral beam section 204 supported by the pair of longitudinal beam sections 203.

The pair of longitudinal beam sections 203 extend in a direction parallel to the Y-axis and are supported by base 202 such that both ends of each of longitudinal beam sections 203 are connected to base 202. This configuration can allow longitudinal beam section 203 to warp in directions of the Z-axis. The pair of longitudinal beam sections 203 are symmetrical to each other with respect to an axis which extends through the center of inertial force sensor 201 and which is parallel to the Y-axis. This configuration allows the pair of longitudinal beam sections 203 to have the substantially same warpage in response to an angular velocity applied to inertial force sensor 201.

Lateral beam section 204 extends in parallel to the X-axis, and have both ends connected to substantial midpoints of respective ones of longitudinal beam sections 203. This structure allows lateral beam section 204 to warp in directions of the Z-axis. The inertial force sensor may further include another layer, such as a barrier layer made of silicon dioxide film ($SiO_2$) or an adhesive layer made of titanium (Ti) on a surface of base 202, longitudinal beam sections 203, and lateral beam sections 204.

Arms 206, 207, 208, and 209 can warp in directions of the X-axis, the Y-axis, and the Z-axis. Arm 206 and arm 207 are symmetrical to each other with respect to an axis parallel to the Y-axis. Arm 208 and arm 209 are symmetrical to each other with respect to an axis parallel to the Y-axis. Arm 206 and arm 209 are symmetrical to each other with respect to an axis parallel to the X-axis. Arm 207 and arm 208 are symmetrical to each other with respect to an axis parallel to the X-axis. This structure allows arms 206 to 209 to warp by the substantially same amount in response to an angular velocity applied to inertial force sensor 201.

Beam section 205, plummet 210, and arms 206 to 209 are made of non-piezoelectric material, such as diamond, fused quartz, alumina, stainless, polymer, or GaAs. Beam section 205, plummet 210, and arms 206 to 209 particularly made of silicon can form an extremely-small inertial force sensor 201 by a microfabrication technique, and allows the sensor integrated with an integrated circuit (IC) constituting a circuit.

Driving section 211 drives and causes the arms to vibrate in a direction parallel to the XY-plane. Detection section 212 detects an inertial force generated by an angular velocity about the Z-axis. Detection section 213 detects an inertial force generated by an angular velocity about the Y-axis. Detection section 214 detects an inertial force generated by an angular velocity about the X-axis.

Connection electrodes 215 are provided at an outer periphery of base 202. Connection electrodes 215 are electrically connected with driving wiring 216 and detection wiring 217 to driving section 211 and detection sections 212, 213, and 214.

Interlayer insulating layer 218 is formed on upper electrode layer 227 or lower electrode layer 228 and piezoelectric layer 220 or Si by, e.g. a chemical vapor deposition (CVD), a physical vapor deposition (PVD), a chemical solution deposition (CSD), and is made of, e.g. SiN, SiON, $SiO_2$, or $Al_2O_3$. Interlayer insulating layer 218 may be formed preferably by an atomic layer deposition (ALD) to form a layer made of $Al_2O_3$ to allow interlayer insulating layer 218 to cover and adhere securely to the electrode layers. A process for forming an $Al_2O_3$ by the ALD does not provide strong reductive atmosphere, thus reducing damages to piezoelectric layer 220.

As shown in FIG. 3, interlayer insulating layer 218 may extend on a side surface of piezoelectric layer 220. This configuration can prevent the deterioration due to the exposure to air of the side surface of piezoelectric layer 220 (e.g., a change of the piezoelectric characteristic due to oxygen ingress), thus avoiding the temporal change of inertial force sensor 201.

FIG. 10A is a cross-sectional view of Inertial force sensor 201 at line 10A-10A shown in FIG. 2. Interlayer insulating layer 218 has contact hole 229 passing through interlayer insulating layer 218 from the upper surface to the lower surface of interlayer insulating layer 218. Via-conductor 229a is provided on an inner wall surface of contact hole 229 and connects wiring 217 on the upper surface of interlayer insulating layer 218 to the upper surface of interlayer insulating layer 218 in the lower surface of interlayer insulating layer 218. Similarly, wirings 216 and 217 provided on the upper surface of interlayer insulating layer 218 are connected to detection sections 213 and 214 and driving section 211 with via-conductor 229a provided on inner wall surfaces of other contact holes passing through interlayer insulating layer 218. Interlayer insulating layer 218 has a large thickness as long as the wiring can be electrically connected. This configuration can reduce the capacitive coupling between upper electrode layer 228 and wirings 216 and 217, thus improving the sensitivity of inertial force sensor 201.

Interlayer insulating layer 218 may not extend on upper surfaces of plummets 210. This configuration allows plummets 210 to be easily processed and trimmed by, e.g. laser in order to reduce the offset of an unnecessary signal and the temperature drift due to an unnecessary vibration of arms 206 to 209.

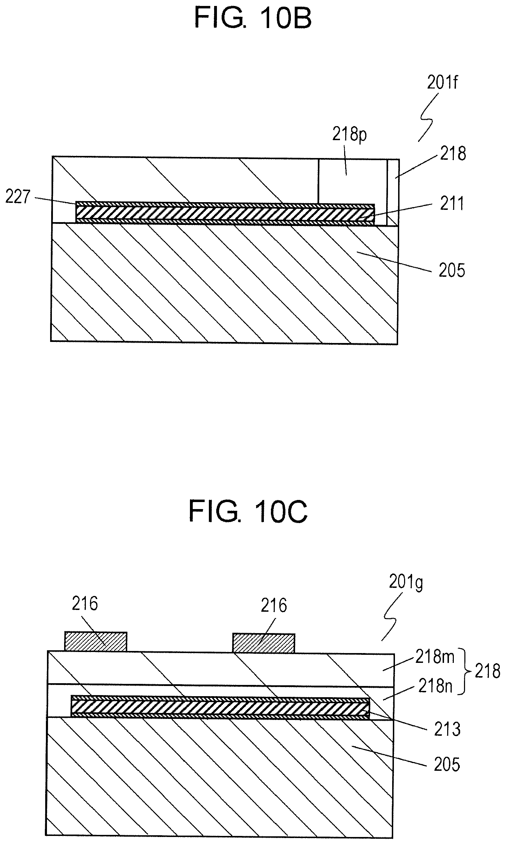

FIG. 10B is a cross-sectional view of further inertial force sensor 201f according to Embodiment 1. In FIG. 10B, components identical to those of inertial force sensor 201 shown in FIG. 3 are denoted by the same reference numerals. Interlayer insulating layer 218 of inertial force sensor 201f shown in FIG. 10B has hole 218p through which upper electrode layer 227 of detection section 212 is exposed from interlayer insulating layer 218. Interlayer insulating layer 218 may has holes therein similar to hole 218p thorough which detection sections 213 and 214 and the upper electrode of driving section 211 are exposed from interlayer insulating layer 218. Each of driving section 211 and detection sections 212 to 214 has a capacitance formed between upper electrode layer 227 and lower electrode layer 228. In the case that driving sections 211 are provided on arms 206 to 209, if driving sections 211 provided on arms 206 to 209 have large capacitances, arms 206 to 209 may not vibrate symmetrically even when the same driving signal is supplied to each driving section 211. If detection sections 212 to 214 provided on various positions on flexible section 251 have capacitances significantly different from one another, detection sections 212 to 214 may output signals having variations in amplitudes or phases. Upper electrode layers 227 of driving section 211 and detection sections 212 to 214 can be trimmed so that the capacitances thereof can be adjusted independently, thereby reducing the variation. Inertial force sensor 201f can prevent interlayer insulating layer 218 from being cut during the trimming of upper electrode layer 227 of driving section 211 and detection sections 212 to 214. This process can prevent interlayer insulating layer 218 from producing scattered residue. For example, the residue of interlayer insulating layer 218 attached to electrode 215 may cause a contact failure of electrode 215. Inertial force sensor 201f can suppress such a contact failure deteriorating reliability.

FIG. 10C is a cross-sectional view of further inertial force sensor 201g according to Embodiment 1. In FIG. 10C, components identical to those of inertial force sensor 201 shown in FIG. 3 are denoted by the same reference numerals. In inertial force sensor 201g, interlayer insulating layer 218 has a layered structure including lower layer 218m and upper layer 218n made of at least one of SiN, SiON, and $SiO_2$ provided on an upper surface of lower layer 218m. Lower layer 218m is made of $Al_2O_3$ and provided on flexible section 251, driving section 211 and the upper surfaces of detection sections 212 to 214. This configuration can form interlayer insulating layer 218 providing characteristics of the respective materials, thus providing interlayer insulating layer 218 superior in resistance, such as chemical resistance and moisture resistance.

Driving section 211 and detection section 212 on arm 206 may arranged in an opposite order. Specifically, driving section 211 may be provided along arm 206 (flexible section 251) to be closer to lateral beam section 204 than detection section 212. Detection section 212 may be provided close to plummet 210. In this case, detection wiring 217 extending from detection section 212 passes along the upper surface of interlayer insulating layer 218 above driving section 211, detection section 213, and detection section 214. This configuration can allow driving section 211 to have a larger area than the arrangement in which detection wiring 217 and driving section 211 are arranged on arm 206. This configuration improves a driving efficiency of inertial force sensor 201g, thus providing inertial force sensor 201g with a small size.

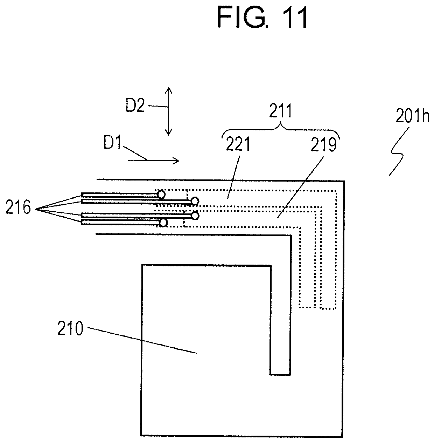

FIG. 11 is a plan view of further inertial force sensor 201h according to Embodiment 1. In FIG. 11, components identical to those of inertial force sensor 201 shown in FIG. 2 are denoted by the same reference numerals. In inertial force sensor 201h, driving section 211 is divided into two parts in width direction D2 perpendicular to direction D1 along which arm 206 extends. As shown in FIG. 11, driving section 211 includes driving sections 219 and 221 spaced in width direction D2. Driving sections 219 and 221 applies a voltage to piezoelectric layer 220 via driving wiring 216. This configuration allows driving sections 219 and 221 provided at upper and lower sides to receive driving signals having phases opposite to each other. This configuration can drive the arm more efficiently along the XY-plane, thus providing inertial force sensor 201h with high sensitivity.

Similarly, in the case that detection sections 212 to 214 detect displacement of flexible section 251 in a direction parallel to the XY-plane, each of detection sections 212 to 214 may be divided into two detection sections arranged in a width direction perpendicular to a direction along which flexible section 251 (arm 206, beam section 205) extends. This configuration allows the detection sections to detect the displacement (warpage) in a direction parallel to the XY-plane of flexible section 251 more efficiency, thus providing inertial force sensor 201h with high sensitivity.

A monitor section that detects a displacement of arm 206 may be provided on arm 206. The monitor section detects a displacement of arm 206 in a direction parallel to the XY-plane to output a monitor signal depending on the displacement. In this case, the wiring extending from the driving section and/or the detection section on arm 206 may extend over interlayer insulating layer 218 provided on an upper surface of the monitor section. The monitor section has a similar structure to detection section 212, and has a lower electrode layer provided on an upper surface of arm 206, a piezoelectric layer provided on an upper surface of the lower electrode layer, and an upper electrode layer provided on an upper surface of the piezoelectric layer. This configuration allows the monitor section to have a larger area than a structure in which both of the wiring and the driving section (or the detection section) are provided on arm 206, thus providing the inertial force sensor with improved sensitivity and a small size.

The wirings extending from the upper electrode layer and the lower electrode layer of the monitor section passes on a portion of interlayer insulating layer 218 above the driving section and/or the detection section. This configuration allows the monitor section (or the detection section) to have a larger area than a structure in which the wiring and the driving section (or a detection section) are arranged, thus providing the inertial force sensor with high sensitivity and a small size.

The same wiring may be used as long as characteristic of a driving/detection signal for detecting an angular velocity has no problem. For example, the same wiring extends from the lower electrode layers of driving sections 219 and 221 based on a position or a shape to be etched and a route of the wiring from the driving section and the detection section. The same wiring can extend from the respective lower electrode layers of detection sections 212, 213, and 214. This configuration can reduce the number of connection electrodes 215 provided at the base, thus providing inertial force sensor 201 with a small size.

Beam section 205, plummets 210, and arms 206 to 209 may be made of piezoelectric material, such as crystal, LiTaOs, or LiNbO$_3$. In this case, an electrode layer made of, e.g. a single metal consisting of at least one of copper, silver, gold, titanium, tungsten, platinum, chromium, or molybdenum or an alloy mainly containing these metals or a layered structure of these metals may be provided on base 202, longitudinal beam sections 203, lateral beam sections 204, plummets 210, and arms 206 to 209 made of the piezoelectric materials to form driving section 211 and detection sections 212, 213, and 214. This configuration allows detection sections 212, 213, and 214 to have larger area than a structure in which the driving wiring and each detection section are arranged on flexible section 251 (arm 206, beam section 205), thus providing inertial force sensor 201 with high sensitivity. Driving section 211 and detection sections 212, 213, and 214 on flexible section 251(arm 206, beam section 205) can have an improved area ratio, and provides inertial force sensor 201 with a small size. The wiring provided above detection section 212 via interlayer insulating layer 218 can increase the strength of driving section 211 and detection section 212, thus providing inertial force sensor 201 with high reliability. In conventional inertial force sensor 101 shown in FIGs. 23 to 25, a stress produced due to vibration of arm 206 may cause a defect, such as a crack or hillock, in driving section 211 or detection section 212, which may reduce reliability. In inertial force sensor 201 according to Embodiment 1, interlayer insulating layer 218 and wirings 216 and 217 have a function of protecting driving section 211 and detection section 212, and provide driving section 211 and detection section 212 with high reliability, hence providing inertial force sensor 201 with high reliability. This configuration is particularly effective for a part, such as region PI shown in FIG. 2, having a stress concentrating thereto.

The above description is for arm 206. Other arms 207 to 209 may have a similar configuration.

Operations of inertial force sensor 201 for detecting an angular velocity according to Embodiment 1 will be described below.

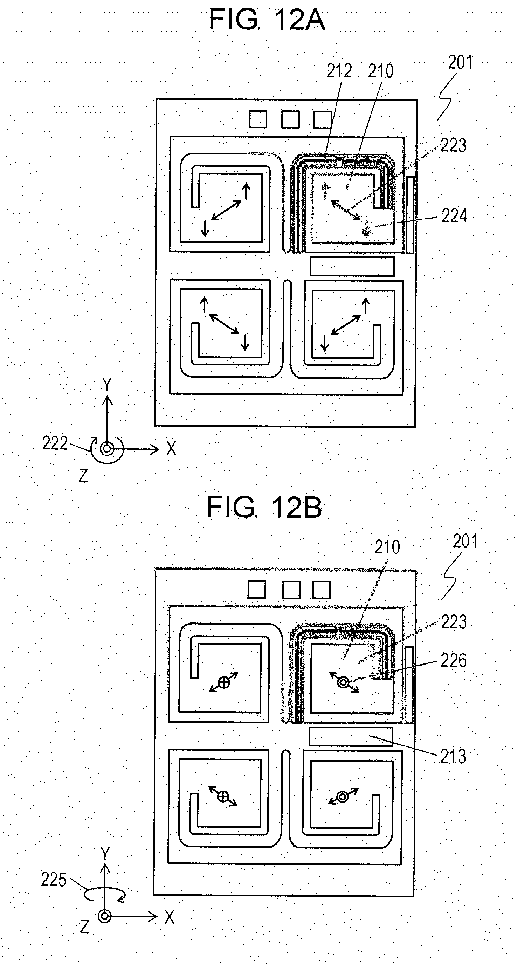

FIG. 12A is a schematic plan view of inertial force sensor 201 for illustrating an operation of detecting angular velocity 222 about the Z-axis. When a driving signal is supplied from a driving circuit to driving section 211, plummet 210 has driving vibration 223 along the XY-plane. When angular velocity 222 about the Z-axis is applied to inertial force sensor 201, an inertial force (Coriolis force) occurs in a direction of the Y-axis and causes plummet 210 to have detection vibration 224. Detection vibration 224 produces a detection signal output from detection section 212. This detection signal has the same frequency as that of driving vibration 223 and has an amplitude depending on angular velocity 222. Therefore, an intensity of the detection signal is measured to detect an amount of angular velocity 222.

FIG. 12B is a schematic plan view of inertial force sensor 201 for illustrating an operation of detecting angular velocity 225 about the Y-axis. Angular velocity 225 about the Y-axis produces an inertial force causing plummet 210 to have detection vibration 226 in directions of the Z-axis. Detection vibration 226 causes detection section 213 to output a detection signal that has the same frequency as that of driving vibration 223 and that has an amplitude depending on angular velocity 225. Therefore, an intensity of this detection signal is measured to detect the amount of angular velocity 225. An angular velocity about the X-axis can be detected similarly to the angular velocity about the Y-axis.

Inertial force sensor 201 according to Embodiment 1 can detect acceleration as well as an angular velocity. In this case, arms 206, 207, 208, and 209 have acceleration detection sections for detecting acceleration. The acceleration detection sections are provided on, e.g. arms 206, 207, 208, and 209, and are made of strain-sensitive resistors having resistance changing in response to strain applied thereon. The strain-sensitive resistors detect the warpage of arms 206, 207, 208, and 209 caused by acceleration to detect the acceleration. When acceleration occurs in, e.g. a direction of the X-axis, the plummets are displaced in the direction of the X-axis, thus resulting in the warpage of arms 206, 207, 208, and 209. This warpage can be detected by the strain-sensitive resistors for detecting the acceleration.

In conventional inertial force sensor 101 shown in FIGs. 23 to 25, wiring 115 extending from driving section 110 and detection section 111 are both provided on the same plane, i.e., the upper surfaces of arms 105, 106, 107, and 108. This structure restricts an area within which detection section 111 can be provided, accordingly reducing sensitivity of inertial force sensor 101 or increasing a size of inertial force sensor 101.

Since the wiring of inertial force sensor 101 has a large electrode capacitance, inertial force sensor 101 have a large noise level and a large power consumption in a circuit section connected to inertial force sensor 101.

In conventional inertial force sensor 101, an increase in the wiring length causes an increase in the capacitance because wiring 115 has a layered structure including upper electrode layer 119, piezoelectric layer 117, and lower electrode layer 118. The wiring having the capacitance causes the inertial force applied to inertial force sensor 101 to produce an unnecessary charge (an unnecessary signal) in the wiring, thus deteriorating an S/V ratio of inertial force sensor 101. Furthermore, the capacitance in a detection circuit becomes a factor causing a noise. Thus, the capacitance of the wiring undesirably deteriorates a noise of inertial force sensor 101.

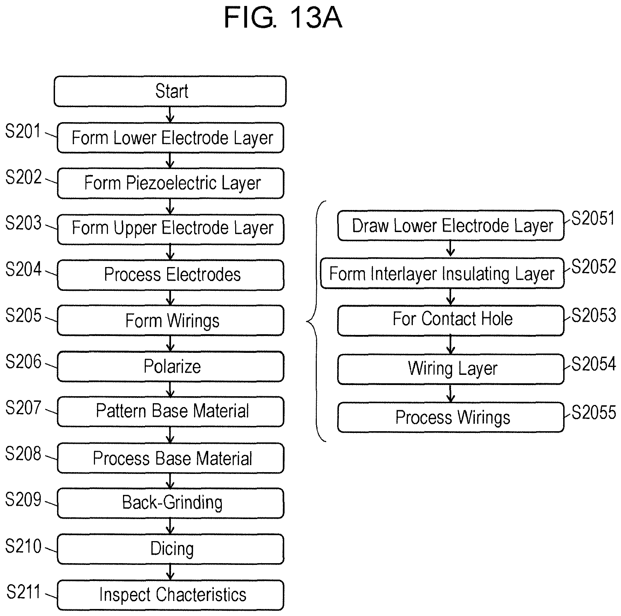

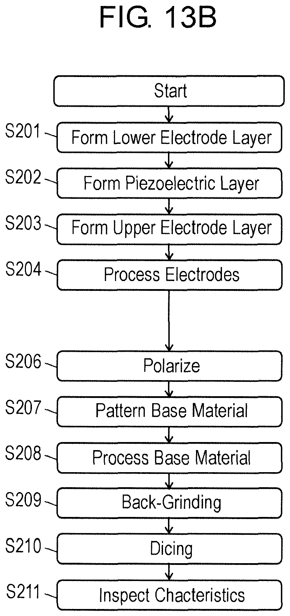

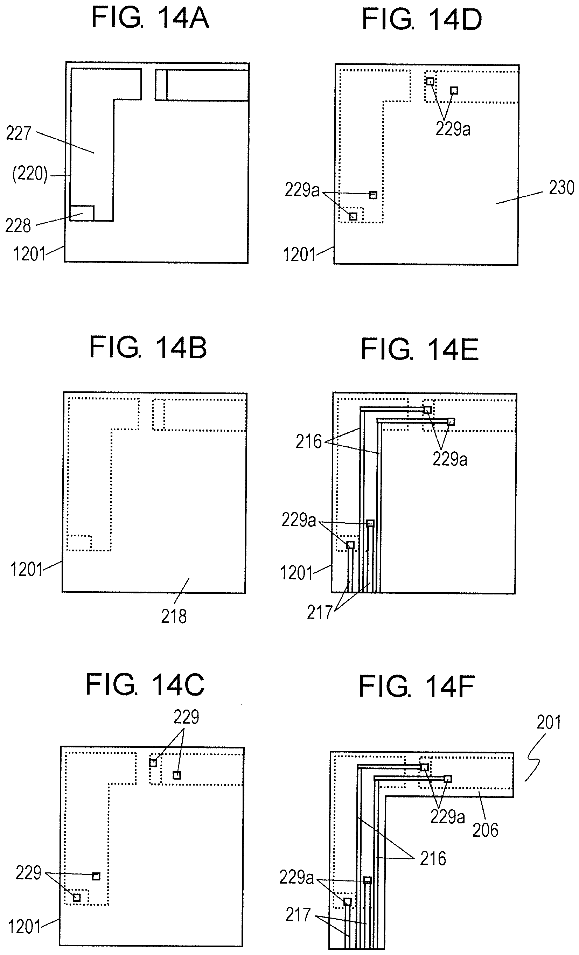

Processes for manufacturing inertial force sensor 201 according to Embodiment 1 will be described below. FIG. 13A illustrates a process for manufacturing inertial force sensor 201 according to Embodiment 1. FIG. 13B illustrates a process for manufacturing conventional inertial force sensor 101 shown in FIGs. 23 to 25 as Comparative Example 1. FIGs. 14A to 14D are a plan view of inertial force sensor 201 for illustrating the processes for manufacturing inertial force sensor 201.

The processes for manufacturing inertial force sensor 201 according to Embodiment 1 will be described below. Base material 1201 for base 202 and flexible section 251 is prepared. Lower electrode layer 228 is formed on an upper surface of base material 1201 (Step S201). Next, piezoelectric layer 220 is formed on an upper surface of lower electrode layer 228 (Step S202). Next, upper electrode layer 227 is formed on an upper surface of piezoelectric layer 220 (Step S203). Next, connection electrodes 215 are processed (Step S204). Next, wirings 216 and 217 are formed (Step S205). Next, the piezoelectric material of piezoelectric layer 220 is polarized (Step S206). Next, base material 1201 is patterned (Step S207). Next, patterned base material 1201 is processed to form base 202 and flexible section 251(arms 206 to 207, beam section 205) (Step S208). Next, a lower surface of base material 1201 is ground (back-grinding, Step S209). Next, base material 1201 is diced to obtain inertial force sensor 201 (Step S210). Next, inertial force sensor 201 obtained is inspected in characteristics (Step S211).

The processes for manufacturing conventional inertial force sensor 101 as Comparative Example 1 will be described below. In FIG. 13B, processes identical to those shown in FIG. 13A of inertial force sensor 201 in Embodiment 1 are denoted by the same reference numerals. The processes for manufacturing inertial force sensor 101 of Comparative Example 1 shown in FIG. 13B do not include processes shown in FIG. 13A for forming wirings.

As shown in FIG. 13A, the processes for forming wirings 216 and 217 (Step S205) are executed between a process for processing the electrode (Step S204) and a processes for polarizing piezoelectric layer 220 (Step S206). In the processes for forming the wirings (Step S205), lower electrode layer 228 is firstly drawn (Step S2051). Next, interlayer insulating layer 218 is formed (Step S2052). Next, contact hole 229 is formed (Step S2053). Next, a wiring layer is formed (Step S2054). Next, wirings 216 and 217 are processed (Step S2055).

The process for forming wirings 216 and 217 (Step S205) will be detailed below. At Step S2051, as shown in FIG. 14A, upper electrode layer 227 and piezoelectric layer 228 are etched to expose a part of lower electrode layer 228.

At Step S2052, as shown in FIG. 14B, interlayer insulating layer 218 is formed on upper electrode layer 227 and lower electrode layer 228 by, e.g. the CVD, the PVD, or vapor deposition.

At Step S2053, as shown in FIG. 14C, interlayer insulating layer 218 is etched to form contact hole 229 to expose a part of upper electrode layer 227 and a part of and lower electrode layer 228 through the contact hole.

At Step S2054, as shown in FIG. 14D, conductive layer 230 is formed by, e.g. the PVD entirely on the upper surface of interlayer insulating layer 218 having contact hole 229 therein shown in FIG. 14C. At this moment, conductive layer 230 is formed also on the inner wall surface of contact hole 229.

At Step S2505, as shown in FIG. 14E, conductive layer 230 is etched to form wirings 216 and 217 that extend through contact hole 229 and that have a predetermined shape. Via-conductor 229a is formed on the inner wall surface of contact hole 229.

Next, piezoelectric layer 220 is polarized (Step S206). As shown in FIG. 14F, base material 1201 is patterned to have a predetermined shape (Step S207) and is processed (Step S208), thereby forming arm 206.

After forming contact hole 229, a metal layer made of, e.g. a single metal consisting of at least one of copper, silver, gold, titanium, tungsten, platinum, chromium, or molybdenum or an alloy mainly containing these metals or a layered structure of these metals is formed by the CVD or PVD on the inner wall surface of contact hole 229. Then, interlayer insulating layer 218 can be further formed on the inner wall surface by the CVD, PVD, or vapor deposition, thereby forming interlayer insulating layer 218 having a multi-layer structure.

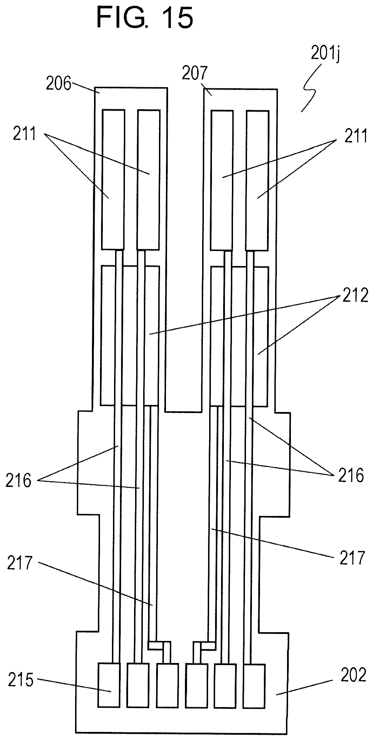

FIG. 15 is a plan view of further inertial force sensor 201j according to Embodiment 1. In FIG. 15, components identical to those of inertial force sensor 201 shown in FIGs. 1 to 3 are denoted by the same reference numerals. Another aspect of inertial force sensor 201 according to Embodiment 1 will be described below. In inertial force sensor 201 shown in FIGs. 1 to 3, flexible section 251 includes beam section 205 and four arms 206 to 209. Inertial force sensor 201j shown in FIG. 15 includes two arms 206 and 207 and base 202 connecting arms 206 and 207. In FIG. 15, wirings extending from the lower electrode layer of each driving section and the lower electrode layer of each detection section are shown. Driving wiring 216 extending from driving section 211 provided on arms 206 and 207 passes on interlayer insulating layer 218 provided on detection section 212. This configuration can provide the same effect as that of inertial force sensor 201 including four arms 206 to 209 connected to beam section 205.

In inertial force sensor 201j shown in FIG. 15, driving wiring 216 extending from driving section 211 provided on arms 206 and 207 passes over detection section 212. Driving section 211 and detection section 212 may be arranged at opposite positions along arms 206 and 207. In this case, the wirings extending from the detection section provided on arms 206 and 207 may pass over driving section 211. This configuration can provide driving section 211 with a large area, thus providing inertial force sensor 201j with high sensitivity.

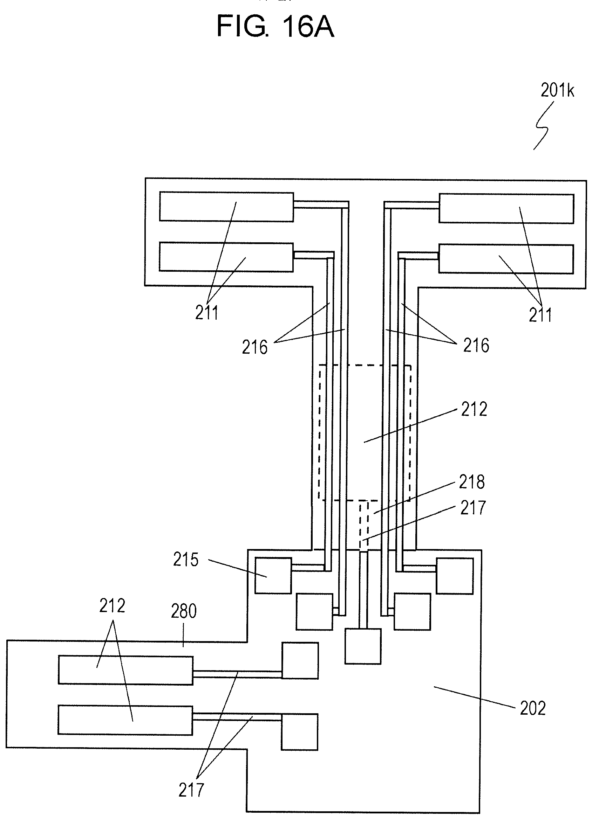

FIG. 16A is a plan view of further inertial force sensor 201k according to Embodiment 1. In FIG. 16A, components identical to those of inertial force sensor 201 shown in FIGs. 1 to 3 are denoted by the same reference numerals. Inertial force sensor 201k shown in FIG. 16A further includes arm 280 extending from base 202 and includes three arms I total.

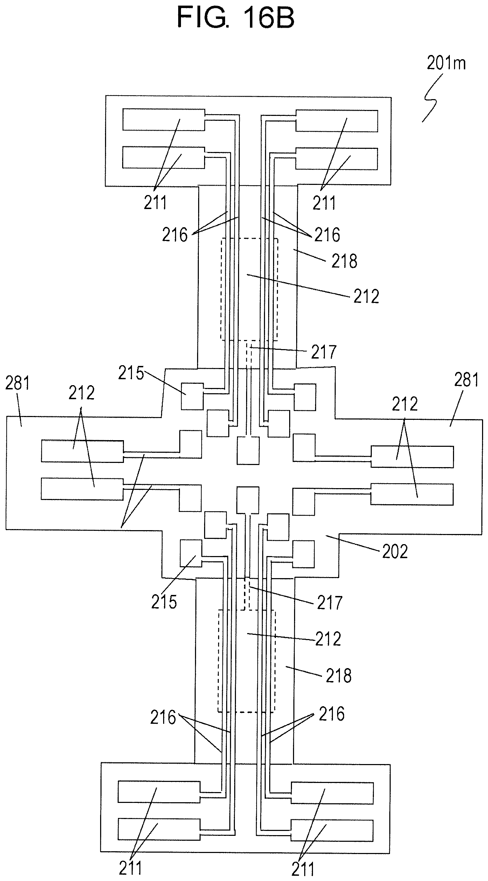

FIG. 16B is a plan view of further inertial force sensor 201m according to Embodiment 1. In FIG. 16B, components identical to those of inertial force sensor 201 shown in FIGs. 1 to 3 are denoted by the same reference numerals. In inertial force sensor 201m shown in FIG. 16B, another pair of arms 281 is provided to be symmetrical to each other with respect to base 202 and includes four arms in total. This structure can suppress a vibration leakage during the driving of inertial force sensor 201m, thus improving an S/N ratio of inertial force sensor 201m.

Illustrative Embodiment 2 not part of the invention but facilitates understanding of the invention.

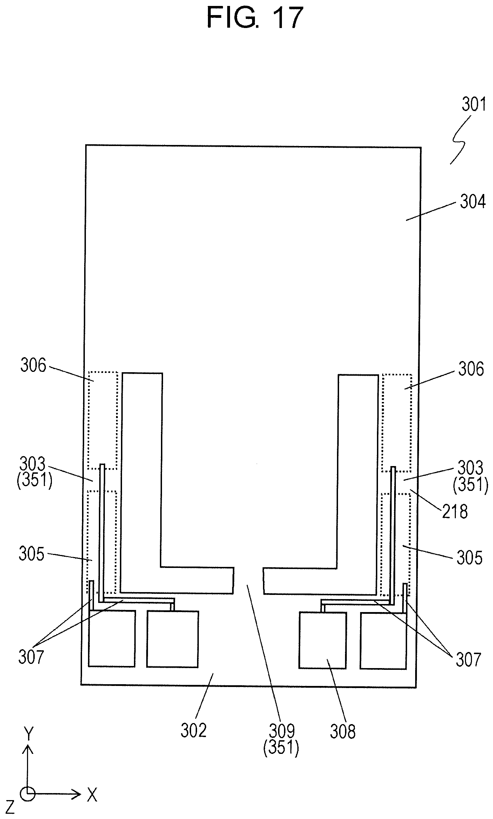

FIG. 17 is a top view of inertial force sensor 301 according to Embodiment 2. Inertial force sensor 301 is for detecting acceleration. In FIG. 17, an X-axis, a Y-axis, and a Z-axis perpendicular to one another are defined. An XY-plane including the X-axis and the Y-axis is defined. Inertial force sensor 301 includes base 302, plummet 304, center support beam section 309, and beam section 303. Center support beam section 309 connects base 302 to plummet 304. Center support beam section 309 and beam section 303 constitute flexible section 351 that can deform to warp. Driving section 305, detection section 306, interlayer insulating layer 218, and connection electrode 308 are provided on upper surface of beam section 303. Interlayer insulating layer 218 is provided on upper surfaces of driving section 305 and detection section 306. Wiring 307 electrically connecting driving section 305 and detection section 306 to connection electrode 308 is provided on upper surface of interlayer insulating layer 218.

Each of driving section 305 and detection section 306 includes a lower electrode layer provided on an upper surface of flexible section 251, a piezoelectric layer provided on an upper surface of the lower electrode layer, and an upper electrode layer provided on an upper surface of the piezoelectric layer.

Wirings 307 extend from the upper electrode layer and the lower electrode layer of detection section 306 and are provided on the upper surface of interlayer insulating layer 218 provided on the upper surface of driving section 305. This configuration allows driving section 305 to have a larger area n increased area than a configuration in which wirings 307 and driving section 305 are arranged on beam section 303, thus providing inertial force sensor 301 with high sensitivity and a small size.

An operation of inertial force sensor 301 according to Embodiment 2 will be described below.

In inertial force sensor 301, a driving signal supplied to driving section 305 causes beam section 303 to vibrate in a direction of the Z-axis or the X-axis. Acceleration applied to the sensor in a direction of the X-axis while the sensor vibrates produces an inertial force on plummet 304. Then, beam sections 303 arranged at positions opposite to each other with respect to support beam section 309 receive a tensile stress and a compression stress, and have a resonance frequency thereof change. Detection section 306 provided on beam section 303 detects the change of the resonance frequency, thus detecting acceleration.

Driving section 305 is provided closer to base 302 along beam section 303 than detection section 306. Detection section 306 is provided closer to plummet 304 along beam section 303 than driving section 305. Wiring 307 extending from detection section 306 passes on interlayer insulating layer 218 provided on driving section 305.

Driving section 305 and detection section 306 may be arranged at opposite positions along beam section 303. That is, detection section 306 may be closer to base 302 along beam section 303 than driving section 305. Driving section 305 may be closer to plummet 304 along beam section 303 than detection section 306. In this case, wiring 307 extending from driving section 305 passes on interlayer insulating layer 218 provided on detection section 306.

This configuration allows detection section 306 to have a larger area than a configuration in which wiring 307 and detection section 306 are arranged on beam section 303, thus providing inertial force sensor 301 with high sensitivity and a small size.

In inertial force sensors 201 and 301 according to Embodiments 1 and 2, portions of interlayer insulating layer 218 provided on upper surfaces of driving section 211 and detection sections 212 to 214 are connected to one another. At least one portion of interlayer insulating layer 218 provided on the upper surfaces of driving section 211 and detection sections 212 to 214 may not be connected to another portion of interlayer insulating layer 218 provided on the upper surfaces of driving section 211 and detection sections 212 to 214 and may be separated from another portion of interlayer insulating layer 218 provided on the upper surfaces of driving section 211 and detection sections 212 to 214, providing the same effects.

Inertial force sensors 201 and 301 according to Embodiments 1 and 2 are an angular velocity sensor or an acceleration sensor that detects an angular velocity or acceleration, but may be an inertial force sensor, such as a pressure sensor. Interlayer insulating layer 218 can reduce the capacitance, and provide the inertial force sensor with high sensitivity and a small size.

Exemplary Embodiment 3

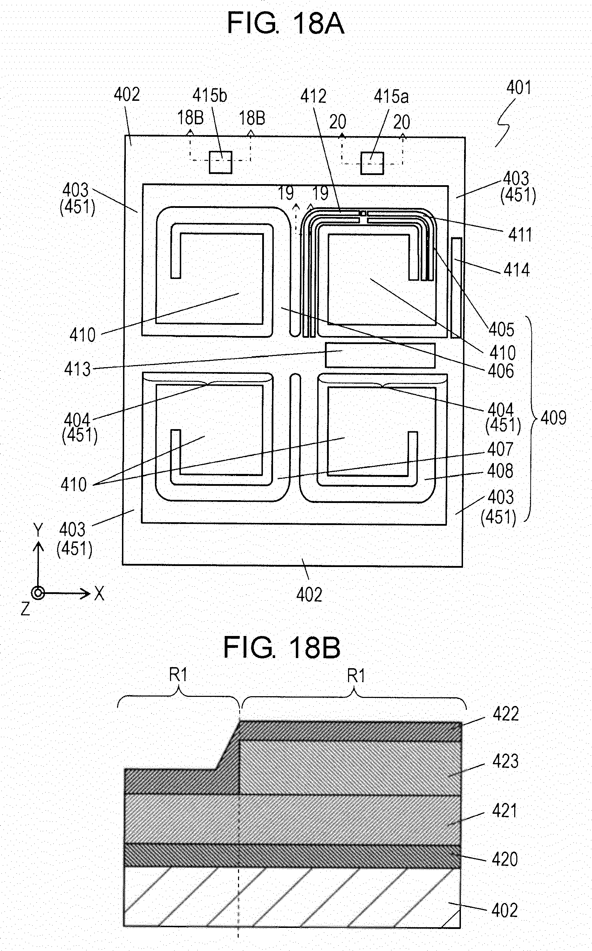

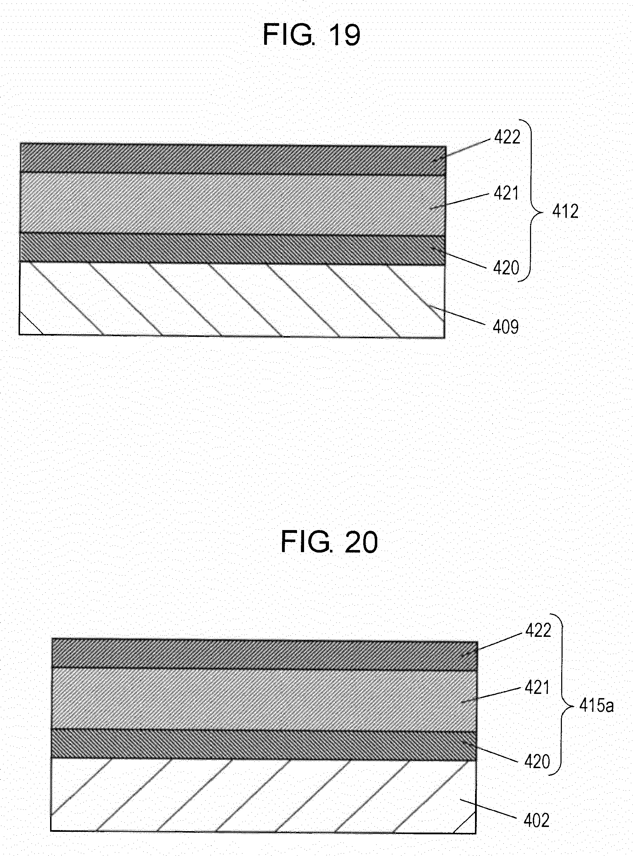

FIG. 18A is a plan view of illustrating inertial force sensor 401 according to Exemplary Embodiment 3. FIG. 18B is a cross-sectional view of inertial force sensor 401 at line 18B-18B shown in FIG. 18A. FIG. 19 is a cross-sectional view of inertial force sensor 401 at line 19-19 shown in FIG. 18A. FIG. 20 is a cross-sectional view of inertial force sensor 401 at line 20-20 shown in FIG. 18A. Inertial force sensor 401 according to Embodiment 3 is an angular velocity sensor that detects an angular velocity.

As shown in FIG. 18A, inertial force sensor 401 includes base 402, flexible section 409 connected to base 402, driving section 411 for causing flexible section 409 to vibrate, detection sections 412 and 413 provided on flexible section 409, and connection electrodes 415a and 415b provided on base 402. Detection sections 412 and 413 detect a displacement of flexible section 409. Connection electrodes 415a and 415b are electrically connected to detection sections 412 and 413, respectively. Connection electrode 415a includes a piezoelectric layer and an electrode layer provided on an upper surface of the piezoelectric layer. Connection electrode 415b includes a piezoelectric layer, an insulating layer covering at least a part of the piezoelectric layer, and an electrode layer provided on an upper surface of the insulating layer.

Connection electrode 415b includes the insulating layer covering at least the part of the piezoelectric layer. Connection electrode 415a includes the piezoelectric layer and the electrode layer. However, the invention is not limited to this. That is, any of connection electrodes 415a and 415b may include the piezoelectric layer, the insulating layer covering at least a part of the piezoelectric layer, and the electrode layer provided on the insulating layer. This configuration allows detection sections 412 and 413 to have substantially the same capacitance. This can consequently reduce a difference in noise between the respective axes. The insulating layer reduces a capacitance caused in the connection electrode, accordingly reducing the noise level.

Base 402 is made of, e.g. diamond, fused quartz, alumina, stainless, polymer, or non-piezoelectric material, such as GaAs. Base 402 particularly made of silicon to provide an extremely small inertial force sensor 401 formed by a microfabrication technique and integrated with an integrated circuit (IC) constituting a circuit.

Flexible section 409 is connected to base 402 and includes driving section 411 and detection sections 412 and 413. When a driving signal is supplied from the driving circuit to driving section 411, at least a part of flexible section 409 vibrates. When an driving signal is supplied to inertial force sensor 401 while the sensor vibrates, a Coriolis force caused by the angular velocity causes flexible section 409 to warp (have a displacement. Then, a charge depending on the warpage is generated in detection sections 412 and 413. A current caused by the charge generated in detection sections 412 and 413 can be input via a wiring and connection electrodes 415a and 415b to the detection circuit, thereby detecting the angular velocity. More specifically, flexible section 409 includes longitudinal beam section 403 supported by base 402, lateral beam section 404 connected to longitudinal beam section 403, and arms 405 to 408 connected to lateral beam section 404. Driving section 411 is provided on arm 405. Longitudinal beam sections 403 and 404 constitute beam section 451. Detection section 412 is provided on arm 405. Detection section 413 is provided on lateral beam section 404. When a driving signal is supplied from the driving circuit to driving section 411, arm 405 vibrates along an XY-plane including the X-axis and the Y-axis. When an angular velocity about the Y-axis is applied while the arm vibrates, a Coriolis force caused by the angular velocity causes lateral beam section 404 to warp in directions of the Z-axis and a charge is generated in detection section 413. A current due to the charge generated in second detection section 413 can be input via a wiring and connection electrode 415a to the detection circuit, thus detecting the angular velocity about the Y-axis. Similarly, the warpage of arm 405 caused by the angular velocity about the Z-axis can be detected as a current caused by a charge generated in detection section 412, thus detecting the angular velocity.

Inertial force sensor 401 according to Embodiment 3 includes two detection sections 412 and 413, but is not limited to this. Inertial force sensor 401 may further include detection section 414. Detection section 414 is provided on longitudinal beam section 403. By detecting a warping caused by an angular velocity about the X-axis as a current due to a charge generated in detection section 414, the angular velocity can be detected.

Inertial force sensor 401 according to Embodiment 3 includes flexible section 409 including four arms 405 to 408, but is not limited to this. Flexible section 409 may include arms 405 and 406 and may not necessarily include arms 407 and 408.

Flexible section 409 is connected to plummet 410. More specifically, plummets 410 are connected to respective one ends of arms 405, 406, 407, and 408 of flexible section 409.

Each of driving section 411 and detection sections 412 and 413 includes a lower electrode layer, a piezoelectric layer, and an upper electrode layer.

FIG. 19 illustrates a cross section of detection section 412. Detection section 412 has a layered structure including lower electrode layer 420 provided on an upper surface of flexible section 409, piezoelectric layer 421 provided on an upper surface of lower electrode layer 420, and upper electrode layer 422 provided on an upper surface of piezoelectric layer 421. Driving section 411, detection section 413, and detection section 414 have the same structure as detection section 412. Lower electrode layer 420 and upper electrode layer 422 are made of, e.g. a single metal consisting of at least one of copper, silver, gold, titanium, tungsten, platinum, chromium, or molybdenum or an alloy mainly containing these metals or a layered configuration of these metals. The electrode layers are preferably made of platinum (Pt) containing Ti or TiOx to provide the electrode layers with high conductivity and stability in high temperature oxidation atmosphere. Another layer, such as an orientation control layer, made of titanate ($PbTiO_3$) may be provided on the upper surface of lower electrode layer 420. According to Embodiment 3, lower electrode layer 420 has a thickness ranging from 100 nm to 500 nm.

Piezoelectric layer 421 is made of piezoelectric material, such as zinc oxide, lithium tantalate, lithium niobate, or potassium niobate. Piezoelectric layer 421 is preferably made of lead zirconate titanate ($Pb(Zr,Ti)O_3$) to provide inertial force sensor 401 with superior piezoelectric characteristics. Another layer, such as an adhesive layer made of titanium (Ti) may be provided on upper surface of piezoelectric layer 421. According to Embodiment 3, piezoelectric layer 421 has a thickness ranging from 1000 nm to 4000 nm.

Base 402, flexible section 409, plummet 410 may be made of piezoelectric material, such as crystal, LiTaOs or $LiNbO_3$. In this case, an electrode layer made of, e.g. a single metal consisting of at least one of copper, silver, gold, titanium, tungsten, platinum, chromium, or molybdenum or an alloy mainly containing these metals or a layered configuration of these metals may be provided on base 402, flexible section 409, and plummet 410 made of these piezoelectric materials, thereby constituting driving section 411 and detection sections 412 and 413. A monitor section that detects the vibration of flexible section 251 may be provided on flexible section 251. Driving section 411 and the monitor section and the driving circuit constitute a driving loop. A driving signal is supplied from this driving circuit via the connection electrode and a wiring to driving section 411 to vibrate arm 405 within the XY-plane. When an angular velocity is applied while the arm vibrates, a charge occurs in at least one of detection sections 412 and 413. A current due to the charge can be input to the detection circuit via a wiring and connection electrodes 415a and 415b, thereby detecting the angular velocity.

Connection electrodes 415a and 415b will be described with referring to FIGs. 20 and 18B, FIG. 20 illustrates a cross section of connection electrode 415a. Connection electrode 415a is provided on the upper surface of base 402. Connection electrode 415a includes lower electrode layer 420 provided on the upper surface of base 402, piezoelectric layer 421 provided on an upper surface of lower electrode layer 420, and upper electrode layer 422 provided on an upper surface of piezoelectric layer 421. Connection electrode 415a is electrically connected to detection section 412 via a wiring. However, Connection electrode 415a may be electrically connected to a detection section other than detection section 412.

FIG. 18B illustrates a cross section of connection electrode 415b. Connection electrode 415b is provided on the upper surface of base 402. Connection electrode 415b includes lower electrode layer 420 provided on the upper surface of base 402, piezoelectric layer 421 provided on an upper surface of lower electrode layer 420, insulating layer 423 provided on at least a part of an upper surface of piezoelectric layer 421, and upper electrode layer 422 provided on an upper surface of piezoelectric layer 421 and the upper surface of insulating layer 423. Connection electrode 415b is electrically connected to detection section 413 via a wiring. However, connection electrode 415b may be electrically connected to a detection section other than detection section 413. Connection electrode 415b is divided to two regions R1 and R2. In region R1, insulating layer 423 provided on the upper surface of piezoelectric layer 421 and upper electrode layer 422 provided on the upper surface of piezoelectric layer 421. In region R2, insulating layer 423 provided on the upper surface of piezoelectric layer 421 and upper electrode layer 422 provided on the upper surface of insulating layer 423.

By adjusting the area or thickness of insulating layer 423, detection section 412 and detection section 413 can have substantially the same capacitance. This configuration can reduce a difference in noise level between the respective axes. The capacitance generated in connection electrode 415b is reduced by the insulating layer, thus reducing a noise level, which will be detailed below.

Capacitance $C_1$ of connection electrode 415a is expressed as represented by Formula 1 with relative permittivity $\varepsilon_{r1}$ of piezoelectric layer 421, film thickness dp ($\mu m$) of the piezoelectric layer, area $S_1$ ($\mu m^2$) of upper electrode layer 422, and permittivity $\varepsilon_0$ (F/m) of vacuum.

$$C_1 = \varepsilon_{r1} \times \varepsilon_0 \times S_1 / d_P \quad \dots \text{(Formula 1)}$$

Capacitance $C_2$ of connection electrode 415b a capacitance obtained by adding capacitance $C_{2A}$ of region R1 which does not including insulating layer 423 and capacitance $C_{2B}$ of region R2 including insulating layer 423.

Capacitance $C_{2A}$ is expressed as Formula 2 with area S2A ($\mu m^2$) of a portion of the electrode layer in region R1, relative permittivity $\varepsilon_{r1}$ of piezoelectric layer 421, film thickness dp ($\mu m$) of piezoelectric layer 421, and permittivity $\varepsilon_0$ (F/m) of vacuum.

$$C_{2A} = \varepsilon_{r1} \times \varepsilon_0 \times S_{2A}/d_P \quad \dots \text{(Formula 2)}$$

Insulating layer 423 has a relative permittivity that is negligibly small with respect to relative permittivity $\varepsilon_{r1}$ of piezoelectric layer 421. Capacitance $C_{2B}$ of region R2 including insulating layer 423 may approximate a capacitance formed in insulating layer 423 even when insulating layer 423 and piezoelectric layer 421 have film thicknesses slightly different film each other. Thus, capacitance $C_{2B}$ may be expressed as Formula 3 with relative permittivity $\varepsilon_{r2}$ of insulating layer 423, area $S_{2B}$ ($\mu m^2$) of a portion of the electrode layer in region R2.

$$C_{2A} = \varepsilon_{r1} \times \varepsilon_0 \times S_{2A}/d_P \quad \dots \text{(Formula 3)}$$

In the case that connection electrodes 415a and 415b have the same area ($S_1 = S_{2A}+S_{2B}$), difference $\Delta C$ between capacitance $C_1$ of connection electrode 415a and capacitance $C_2$ of connection electrode 415b is expressed as Formula 4.

$$\Delta C = C_1 \cdot C_2$$
$$= C_1 \cdot (C_{2A}+C_{2B})$$
$$= (\varepsilon_{r1} \times \varepsilon_0 \times S_1/d_P) \cdot (\varepsilon_{r1} \times \varepsilon_0 \times S_{2A}/d_P + \varepsilon_{r2} \times \varepsilon_0 \times S_{2B}/d_P)$$
$$= (\varepsilon_{r1} \cdot \varepsilon_{r2}) \times \varepsilon_0 \times S_{2B}/d_P \quad \dots \text{(Formula 4)}$$

As described above, insulating layer 423 between electrode layers 420 and 422 allows connection electrode 415b to have capacitance $C_2$ smaller than capacitance $C_1$ of connection electrode 415a. Furthermore, by appropriately adjusting area $S_{2B}$ of region R2 including insulating layer 423, difference $\Delta C$ of the capacitances can be adjusted arbitrarily. Detection sections 412 to 414 often have different capacitances. Portions of flexible section 409 having detection sections 412 to 414 provided thereon have different rigidities depending on the respective shapes of the portions. Warpages (displacements) of the portions of flexible section 409 produced due to an inertial force received at the portions are different from each other. In order to allow detection sections 412 to 414 to have the same sensitivity, that is, to have the same amounts of charges produced in detection sections 412 to 414 due to an inertial force having the same amount, the size, such as the areas, of detection sections 412 to 414 are adjusted depending on rigidities at portions of flexible section 409 having detection sections 412 to 414 provided thereon. The difference of the sizes of detection sections 412 to 414 causes a difference of the capacitances of detection sections 412 to 414. When detection sections 412 to 414 have different sensitivities and capacitances, signals detected by detection sections 412 to 414 have phase different from each other, thus increasing jitter noise in the detection circuit. Alternatively, a circuit processing section provided at a stage prior to detection requires a phase shifter to correct the above phase differences of the detection signal, hence increasing the size of the circuit. In inertial force sensor 401 according to Embodiment 3, difference $\Delta C$ between capacitance $C_1$ of connection electrode 415a and capacitance $C_2$ of connection electrode 415b can be arbitrarily adjusted as to cancel the difference of the capacitances of detection sections 412 to 414 while allowing detection sections 412 to 414 to have the same sensitivity. This configuration can suppress the jitter noise generated between detection signals, thus reducing the noise level of inertial force sensor 401. This configuration can eliminate a phase shifter in the detection circuit, thus providing inertial force sensor 401 with a small size. Furthermore, the capacitances of detection sections 412 to 414 can be adjusted such that based on a detection section out of detection sections 412 to 414 having the smallest capacitance, the other detection sections may have capacitances equal to the smallest capacitance. This configuration can reduce capacitances of detection sections 412 to 414 while cancelling the difference of the capacitances of detection sections 412 to 414. A noise generated when signals from detection sections 412 to 414 are amplified is mainly caused by an amplifier, and increases as an increase of the capacitances of the electrodes. Inertial force sensor 401 according to Embodiment 3 can reduce this noise caused when the signals from detection sections 412 to 414 are amplified, hence reducing the noise level of inertial force sensor 401.

In conventional inertial force sensor 101 shown in FIG. 23, detection sections 111, 112, and 113 contain electrode material and piezoelectric material, and utilize a piezoelectric effect to extract, as charge, the deflection caused by an inertial force applied to arms 105 to 108, longitudinal beam section 103, and lateral beam section 104. A current due to the charge is to be processed to detect the inertial force.

In conventional inertial force sensor 101, arms 105 to 108, longitudinal beam section 103, and lateral beam section 104 have different shapes, and thus, warp unevenly upon having an inertial force applied thereto from outside. As described above, inertial force sensor 101 extracts, as charge, the deflection of arms 105 to 108, longitudinal beam section 103, and lateral beam section 104 due to the inertial force by utilizing the piezoelectric effect of detection sections 111, 112, and 113 provided on longitudinal beam section 103, and lateral beam section 104. Thus, different warpages of arms 105 to 108, longitudinal beam section 103, and lateral beam section 104 cause a different charge amount (hereinafter signal level) caused in the detection sections even when the same amount of the inertial force is applied. More specifically, a detection section provided on a member which hardly warps provides a small signal level. To prevent this, in conventional inertial force sensor 101, each detection section is allowed to have a fixed signal level or more by allowing a member that is hard to deflect to have thereon a detection section having an increased area so as to increase the member that is hard to deflect obtained by the piezoelectric effect.

The detection sections having different areas depending on the warpage of the member provide a difference between capacitances of the detection sections. This undesirably causes a different noise level between the detection sections (i.e., between the axes).

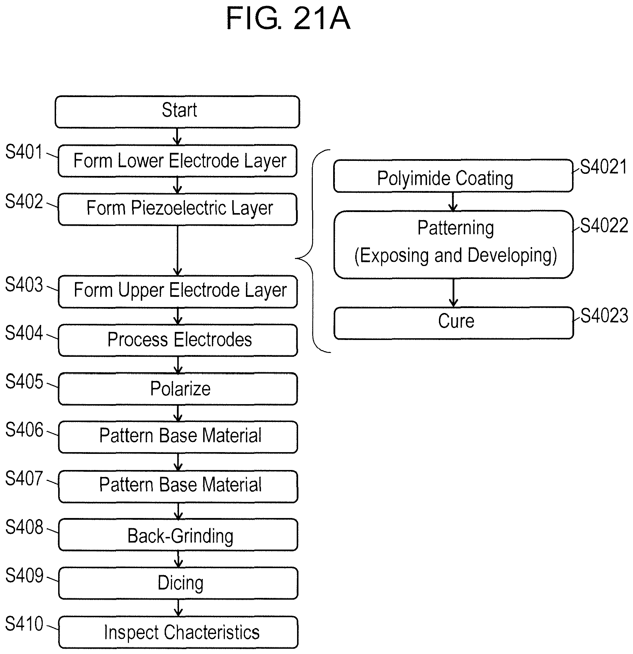

FIG. 21A illustrates processes for manufacturing inertial force sensor 401 according to Embodiment 3. Abase material to be base 402 and flexible section 409 is prepared. Lower electrode layer 420 is formed on an upper surface of the base material (Step S401). Next, piezoelectric layer 421 is formed on an upper surface of lower electrode layer 420 (Step S402). Next, insulating layer 423 is formed on at least a part of an upper surface of piezoelectric layer 421 (Steps S4021, S4022, and S4023). Next, upper electrode layer 422 is formed (Step S403). Next, connection electrodes 415a and 415b are processed (Step S404). Next, the piezoelectric material of piezoelectric layer 421 is polarized (Step S405). Next, the base material is patterned (Step S406). Next, the patterned base material is processed to form base 402 and flexible section 251 (Step S407). Next, a lower surface of the base material is ground (back-grinding, Step S408). Next, the base material is diced to provide inertial force sensor 401 (Step S409). Next, inertial force sensor 401 is inspected in characteristics thereof (Step S410).

In the process for forming insulating layer 423, polyimide as material of insulating layer 423 is coated on at least a part of the upper surface of piezoelectric layer 421 (Step S4021). Next, the coated polyimide is patterned (Step S4022). Next, the patterned polyimide is cured (Step S4023).

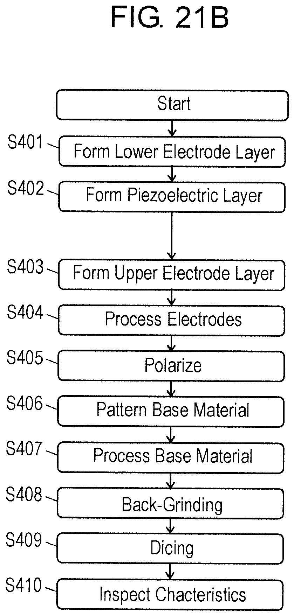

FIG. 21B illustrates processes for manufacturing an inertial force sensor of Comparative Example 2. In FIG. 21B, processes identical to those of inertial force sensor 401 according to Embodiment 3 shown in FIG. 21A are denoted by the same reference numerals. The processes for manufacturing the inertial force sensor of Comparative Example 2 shown in FIG. 21B does not include a process for forming insulating layer 423 included in the processes for manufacturing inertial force sensor 401 according to Embodiment 3 shown in FIG. 21A.

According to Embodiment 3, insulating layer 423 is made of alkali development-type photosensitive polyimide that is photosensitive polyimide including diazonaphthoquinone (DNQ) as photosensitizing agent. Diazonaphthoquinone functioning as photosensitizing agent is widely used as positive resist photosensitizing agent, and can provide alkali development. In the process for exposing and developing the alkali development-type photosensitive polyimide, a photochemical reaction (photopolymerization reaction) due to exposure turns diazonaphthoquinone as a photoreceptor into indenecarboxylic acid via indeneketene. Since this indenecarboxylic acid is highly-soluble to alkali solution, a part irradiated with light is dissolved and a polymer part not subjected to the exposure remains. Diazonaphthoquinone also functions as a dissolution inhibitor to the polymer part. When the dissolution inhibitor subjected to patterning is subjected to a heat treatment as a cure treatment, the imidization reaction (dewatering cyclization) of polyamide acid (polyamic acid) as a polyimide precursor is promoted, thus providing polyimide. After polyamide acid is dissolved in organic solvent and turns into polyimide, the polyimide is not dissolved in organic solvent. Thus, prior to the patterning, solution in which polyamide acid is coupled to organic solvent including photosensitizing agent is coated and dried (or prebaked) and is subjected to an exposure/development process to form a predetermined pattern. Then, the pattern is subjected to a heat treatment to be cured, thereby forming a pattern of insulating layer 423 (polyimide) at a predetermined position.

According to Embodiment 3, insulating layer 423 is made of organic material, but is not limited to this. Inorganic material, such as SiN or $SiO_2$, can be patterned to form insulating layer 423.

According to Embodiment 3, connection electrode 415a has a layered structure including lower electrode layer 420, piezoelectric layer 421, and upper electrode layer 422, but is not limited to this configuration.

According to Embodiment 3, each of connection electrodes 415a and 415b includes piezoelectric layer 421 and insulating layer 423 covering at least a part of the upper surface of piezoelectric layer 421, but is not limited to this configuration. Each of connection electrodes 415a and 415b may include piezoelectric layer 421 and insulating layer 423 covering at least a part of the upper surface of piezoelectric layer 421. Furthermore, each of connection electrodes 415a and 415b may have a configuration in which insulating layer 423 entirely covers the upper surface of piezoelectric layer 421. Any of the above configurations allows difference $\Delta C$ between capacitance C1 of connection electrode 415a and capacitance C2 of connection electrode 415b while allowing detection sections 412 to 413 to have the same sensitivity, thus cancelling the capacitance difference among detection sections 412 to 414.

Exemplary Embodiment 4

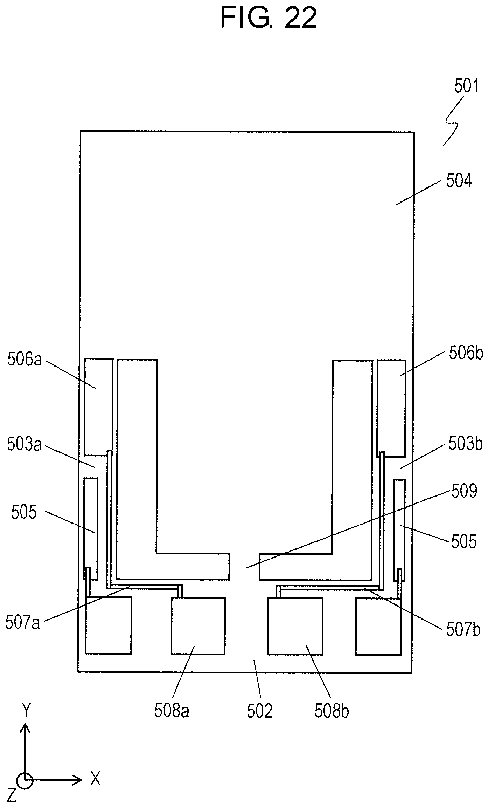

FIG. 22 is a top view of inertial force sensor 501 according to Embodiment 4. Inertial force sensor 501 is an acceleration sensor for detecting acceleration. In FIG. 22, an X-axis, a Y-axis, and a Z-axis perpendicular to one another are defined.

Inertial force sensor 501 includes base 502, plummet 504, center support beam section 509 for connecting base 502 to plummet 504, and beam sections 503a and 503b. Inertial force sensor 501 further includes driving section 505, detection sections 506a and 506b, connection electrodes 508a and 508b, and wirings 507a and 507b. Driving section 505 is provided on beam sections 503a and 503b. Detection sections 506a and 506b are provided on beam sections 503a and 503b, respectively. Connection electrodes 508a and 508b are provided on base 502. Wiring 507a electrically connects detection section 506a to connection electrode 508a. Wiring 507b electrically connects detection section 506b to connection electrode 508b. Connection electrode 508a has the same configuration as that of connection electrode 415a according to Embodiment 3 shown in FIG. 20. Connection electrode 508b has the same configuration as that of connection electrode 415b according to Embodiment 3 shown in FIG. 18B. That is, connection electrode 508b has a capacitance smaller than that of connection electrode 508a.

In this configuration, the capacitances of detection sections 506a and 506b can be cancelled to allow connection electrodes 508a and 508b to have the same capacitance, thus reducing the noise level difference. In this configuration, insulating layer 423 reduces the capacitance caused in connection electrode 508b, thus reducing the noise level. This will be detailed below.

In inertial force sensor 501, beam sections 503a and 503b have resonance frequencies different from each other by a predetermined mistuned frequency by arranging beam sections 503a and 503b asymmetrically to each other about the Y-axis. Thus, beam section 503a and beam section 503b warp differently from each other. As a result, detection sections 506a and 506b are asymmetrical to each other about the Y-axis, thus causing detection sections 506a and 506b to have different capacitances. In inertial force sensor 501, insulating layer 423 allows connection electrode 508b to have a capacitance that can be adjusted (or reduced), and the capacitance difference between detection sections 506a and 506b can be cancelled to allow connection electrodes 508a and 508b to have the same capacitance, thus reducing the noise level difference. As a result, the detection sections can reduce a noise level difference between the detection sections.

A configuration of inertial force sensor 501 will be described below.

Center support beam section 509 and beam sections 503a and 503b extend from base 502 to be parallel to each other. Center support beam section 509 is provided between beam sections 503a and 503b.

Plummet 504 is connected to one ends of center support beam section 509 and beam sections 503a and 503b. As a result, acceleration (inertial force) applied to plummet 504 causes beam sections 503a and 503b to warp.

Base 502, center support beam section 509, beam sections 503a and 503b, and plummet 504 are made of non-piezoelectric material, such as diamond, fused quartz, alumina, stainless, polymer, or GaAs. In particular, the above components made of silicon forms small inertial force sensor 501 by a microfabrication technique and allows inertial force sensor 501 to be integrated with an integrated circuit (IC) configuring a circuit. Another layer, such as a barrier layer made of silicon dioxide film ($SiO_2$) or an adhesive layer made of titanium (Ti) may be provided on base 502, center support beam section 509, beam section 503a, beam section 503b, and plummet 504.

Each of driving section 505 and detection sections 506a and 506b includes an upper electrode layer, a lower electrode layer, and a piezoelectric layer provided between the upper electrode layer and the lower electrode layer.

An operation of inertial force sensor 501 will be described below.

In inertial force sensor 501, when a driving signal is supplied to driving section 505, beam sections 503a and 503b vibrate in directions of the Z-axis or the X-axis. Acceleration applied in X-axis direction while beam sections 503a and 503b vibrate causes an inertial force in plummet 504. Then, a tensile stress is applied to one of beam section 503a and beam section 503b provided at sides opposite to each other with respect to center support beam section 509, and a compression stress is applied to the other. These forces change the resonance frequency of beam sections 503a and 503b. This change is detected by detection sections 506a and 506b provided on beam sections 503a and 503b, thereby detecting the acceleration.

Inertial force sensors 401 and 501 according to Embodiments 3 and 4 are an angular velocity sensor and an acceleration sensor. However, the sensors can be applied to another inertial force sensor, such as a pressure sensor, to reduce the electrode capacitance. Thus, the inertial force sensor can have high sensitivity a small size.

Connection electrode 215 of inertial force sensors 201 and 301 according to Embodiments 1 and 2 may have the same structure as those of connection electrodes 415a and 415b according to Embodiments 3 and 4 to provide the same effect.

In Embodiments 1 to 4, terms, such as "upper surface" an "above", indicating directions indicate relative directions depending only on a relative positional relation between components such as an arm, a driving section, a detection section, and an interlayer insulating layer, of an inertial force sensor, and do not indicate absolute directions, such as a vertical direction.

INDUSTRIAL APPLICABILITY

An inertial force sensor according to the present invention has high sensitivity and a small size, and thus, is useful as an inertial force sensor for various electronic devices for the posture control and navigation for example of a movable body such as an airplane, an automobile, a robot, a ship, and a vehicle.

REFERENCE MARKS

201 Inertial Force Sensor
202 Base
205 Beam Section
211 Driving Section
212, 213, And 214 Detection Section
215 Connection Electrode (First Connection Electrode, Second Connection Electrode)
216 Wiring
217 Wiring
218 Interlayer Insulating Layer (First Interlayer Insulating Layer, Second Interlayer Insulating Layer, And Third Interlayer Insulating Layer)
218a Interlayer Insulating Layer (First Interlayer Insulating Layer)
218b Interlayer Insulating Layer (Second Interlayer Insulating Layer)
220 Piezoelectric Layer
227 Upper Electrode Layer
228 Lower Electrode Layer
231 Metal Layer
251 Flexible Section
401 Inertial Force Sensor
402 Base
409 Flexible Section
411 Driving Section
412, 413, And 414 Detection Section
415a Connection Electrode
415b Connection Electrode
420 Lower Electrode Layer
421 Piezoelectric Layer
422 Upper Electrode Layer
423 Insulating Layer

**Claims**

1.  An inertial force sensor comprising:

    a base (202, 402);
    a first connection electrode (215, 415a) provided on the base;
    a flexible section (205, 206-209, 251, 409) supported by the base;
    a driving section (211, 411) that is provided on an upper surface of the flexible section and that causes the flexible section to vibrate;
    a first detection section (212, 412) that is provided on the upper surface of the flexible section and that detects a displacement of the flexible section;
    a first interlayer insulating layer (218, 218a) provided on an upper surface of one of the driving section and the first detection section; and
    a first wiring (216, 217) electrically connecting another of the driving section and the first detection section to the first connection electrode via an upper surface of the first interlayer insulating layer;
    wherein the inertial force sensor is **characterized by** further comprising:

a second detection section (213, 413) that is provided on the upper surface of the flexible section and that detects the displacement of the flexible section;

a second interlayer insulating layer (218b, 218c) provided on an upper surface of the second detection section;

a second connection electrode (215, 415b) provided on the base; and

a second wiring electrically connecting the one of the first detection section and the driving section to the second connection electrode via the upper surface of the second interlayer insulating layer,

wherein the first wiring electrically connects the another of the first detection section and the driving section to the first connection electrode via an upper surface of the second interlayer insulating layer, and

wherein at least one of the first connection electrode (415a) and the second connection electrode (415b) includes:

a first piezoelectric layer (421);

a first insulating layer (423) covering a part of the first piezoelectric layer; and

a first electrode layer (422) provided on the first insulating layer.

2. The inertial force sensor according to claim 1, further comprising;

a third detection section (214, 414) that is provided on the upper surface of the flexible section and that detects the displacement of the flexible section;

a third interlayer insulating layer (218c) provided on an upper surface of the third detection section;

a third connection electrode provided on the base; and

a third wiring electrically connecting the second detection section to the third connection electrode via an upper surface of the third interlayer insulating layer.

3. The inertial force sensor according to claim 2,

wherein the first wiring electrically connects the another of the first detection section and the driving section to the first connection electrode via the upper surface of the first interlayer insulating layer, the upper surface of the second interlayer insulating layer, and the upper surface of the third interlayer insulating layer, and

wherein the second wiring electrically connects the one of the first detection section and the driving section to the second connection electrode via the upper surface of the second interlayer insulating layer and the upper surface of the third interlayer insulating layer.

4. The inertial force sensor according to claim 2 or 3, wherein the first interlayer insulating layer, the second interlayer insulating layer, and the third interlayer insulating layer are connected to one another.

5. The inertial force sensor according to claim 1, wherein the first detection section and the second detection section have sizes different from each other.

6. The inertial force sensor according to claim 1, wherein each of the first detection section and the second detection section includes:

a second piezoelectric layer (220, 421); and

a second electrode layer (227, 422) provided on the second piezoelectric layer.

7. The inertial force sensor according to claim 1, further comprising:

a third detection section that is provided on the flexible section and that detects the displacement of the flexible section; and

a third connection electrode that is provided on the base and that is electrically connected to the third detection section.

8. The inertial force sensor according to claim 1, wherein the flexible section includes:

a beam section (205); and

an arm (206-209) connected to the beam section.

9. The inertial force sensor according to claim 1, further comprising:

a second connection electrode provided on the base;
a third interlayer insulating layer provided on an upper surface of the first wiring; and
a second wiring electrically connecting the one of the first detection section and the driving section to the second connection electrode via an upper surface of the third interlayer insulating layer.

10. The inertial force sensor according to claim 1, further comprising: a metal layer (231) provided in the third interlayer insulating layer.

11. The inertial force sensor according to claim 10, wherein the metal layer is configured to be connected to a reference potential.

12. The inertial force sensor according to claim 1, wherein the first interlayer insulating layer (218) has a hole (229) allowing the one of the first detection section and the driving section to be exposed from the first interlayer insulating layer through the hole.

13. The inertial force sensor according to any one of claims 1 to 12, wherein the second interlayer insulating layer (218b) is connected to the first interlayer insulating layer (218a).

14. The inertial force sensor according to claim 1, wherein each of the driving section and the first detection section includes:

a lower electrode (228, 420) provided on the upper surface of the flexible section;
a piezoelectric layer (220, 421) provided on an upper surface of the lower electrode; and
an upper electrode (227, 422) provided on an upper surface of the piezoelectric layer.

15. The inertial force sensor according to claim 14, wherein the piezoelectric layer (227) has a side surface covered with the first interlayer insulating layer.

16. The inertial force sensor according to claim 1, further comprising a plummet (210, 410) connected to the flexible section.

17. The inertial force sensor according to claim 16, wherein the first interlayer insulating layer does not extend to the plummet.

**Patentansprüche**

1. Trägheitskraft-Sensor, der umfasst:

einen Sockel (202, 402);
eine erste Verbindungs-Elektrode (215, 415a), die sich auf dem Sockel befindet;
einen flexiblen Teilabschnitt (205, 206-209, 251, 409), der von dem Sockel getragen wird;
einen Ansteuerungs-Teilabschnitt (211, 411), der sich an einer Oberseite des flexiblen Teilabschnitts befindet und der bewirkt, dass der flexible Teilabschnitt vibriert;
einen ersten Erfassungs-Teilabschnitt (212, 412), der sich an der Oberseite des flexiblen Teilabschnitts befindet und der eine Verschiebung des flexiblen Teilabschnitts erfasst;
eine erste isolierende Zwischenschicht (218, 218a), die sich an einer Oberseite des Ansteuerungs-Teilabschnitts oder des ersten Erfassungs-Teilabschnitts befindet; und
eine erste Verdrahtung (216, 217), die den Ansteuerungs-Teilabschnitt und den ersten Erfassungs-Teilabschnitt über eine Oberseite der ersten isolierenden Zwischenschicht elektrisch mit der ersten Verbindungs-Elektrode verbindet;
wobei der Trägheitskraft-Sensor **dadurch gekennzeichnet ist, dass** er des Weiteren umfasst:

einen zweiten Erfassungs-Teilabschnitt (213, 413), der sich an der Oberseite des flexiblen Teilabschnitts befindet und der die Verschiebung des flexiblen Teilabschnitts erfasst;
eine zweite isolierende Zwischenschicht (218b, 218c), die sich an einer Oberseite des zweiten Erfassungs-Teilabschnitts befindet;
eine zweite Verbindungs-Elektrode (215, 415b), die sich auf dem Sockel befindet; sowie eine zweite Verdrahtung, die den ersten Erfassungs-Teilabschnitt und den Ansteuerungs-Teilabschnitt über die Oberseite der zweiten isolierenden Zwischenschicht elektrisch mit der zweiten Verbindungs-Elektrode verbindet; wobei die erste Verdrahtung den anderen von dem ersten Erfassungs-Teilabschnitt und dem Ansteuerungs-Teilabschnitt über eine Oberseite der zweiten isolierenden Zwischenschicht elektrisch mit der ersten Verbindungs-Elektrode verbindet; und die erste Verbindungs-Elektrode (415a) oder/und die zweite Verbindungs-Elektrode (415b) enthält/enthalten:

  eine erste piezoelektrische Schicht (421);
  eine erste isolierende Schicht (423), die einen Teil der ersten piezoelektrischen Schicht abdeckt; und
  eine erste Elektroden-Schicht (422), die sich auf der ersten isolierenden Schicht befindet.

2. Trägheitskraft-Sensor nach Anspruch 1, der des Weiteren umfasst;
einen dritten Erfassungs-Teilabschnitt (214, 414), der sich an der Oberseite des flexiblen Teilabschnitts befindet und der die Verschiebung des flexiblen Teilabschnitts erfasst;
eine dritte isolierende Zwischenschicht (218c), die sich an einer Oberseite des dritten Erfassungs-Teilabschnitts befindet;
eine dritte Verbindungs-Elektrode, die sich auf dem Sockel befindet; sowie
eine dritte Verdrahtung, die den zweiten Erfassungs-Teilabschnitt über eine Oberseite der dritten isolierenden Zwischenschicht elektrisch mit der dritten Verbindungs-Elektrode verbindet.

3. Trägheitskraft-Sensor nach Anspruch 2,
wobei die erste Verdrahtung den anderen von dem ersten Erfassungs-Teilabschnitt und dem Ansteuerungs-Teilabschnitt über die Oberseite der ersten isolierenden Zwischenschicht, die Oberseite der zweiten isolierenden Zwischenschicht und die Oberseite der dritten isolierenden Zwischenschicht elektrisch mit der ersten Verbindungs-Elektrode verbindet, und
wobei die zweite Verdrahtung den einen von dem ersten Erfassungs-Teilabschnitt und dem Ansteuerungs-Teilabschnitt über die Oberseite der zweiten isolierenden Zwischenschicht und die Oberseite der dritten isolierenden Zwischenschicht elektrisch mit der zweiten Verbindungs-Elektrode verbindet.

4. Trägheitskraft-Sensor nach Anspruch 2 oder 3, wobei die erste isolierende Zwischenschicht, die zweite isolierende Zwischenschicht und die dritte isolierende Zwischenschicht miteinander verbunden sind.

5. Trägheitskraft-Sensor nach Anspruch 1, wobei der erste Erfassungs-Teilabschnitt und der zweite Erfassungs-Teilabschnitt voneinander verschiedene Größen haben.

6. Trägheitskraft-Sensor nach Anspruch 1, wobei der erste Erfassungs-Teilabschnitt und der zweite Erfassungs-Teilabschnitt jeweils enthalten:

  eine zweite piezoelektrische Schicht (220, 421); und
  eine zweite Elektroden-Schicht (227, 422), die sich auf der zweiten piezoelektrischen Schicht befindet.

7. Trägheitskraft-Sensor nach Anspruch 1, der des Weiteren umfasst:

  einen dritten Erfassungs-Teilabschnitt, der sich an dem flexiblen Teilabschnitt befindet und der die Verschiebung des flexiblen Teilabschnitts erfasst; sowie
  eine dritte Verbindungs-Elektrode, die sich auf dem Sockel befindet und die elektrisch mit dem dritten Erfassungs-Teilabschnitt verbunden ist.

8. Trägheitskraft-Sensor nach Anspruch 1, wobei der flexible Teilabschnitt enthält:

  einen Träger-Teilabschnitt (205); sowie
  einen Arm (206-209), der mit dem Träger-Teilabschnitt verbunden ist.

9. Trägheitskraft-Sensor nach Anspruch 1, der des Weiteren umfasst:

  eine zweite Verbindungs-Elektrode, die sich auf dem Sockel befindet;
  eine dritte isolierende Zwischenschicht, die sich an einer Oberseite der ersten Verdrahtung befindet, sowie

eine zweite Verdrahtung, die den ersten Erfassungs-Teilabschnitt oder den Ansteuerungs-Teilabschnitt über eine Oberseite der dritten isolierenden Zwischenschicht elektrisch mit der zweiten Verbindungs-Elektrode verbindet.

10. Trägheitskraft-Sensor nach Anspruch 1, der des Weiteren eine Metall-Schicht (231) umfasst, die sich in der dritten isolierenden Zwischenschicht befindet.

11. Trägheitskraft-Sensor nach Anspruch 10, wobei die Metall-Schicht so eingerichtet ist, dass sie mit einem Bezugspotenzial verbunden ist.

12. Trägheitskraft-Sensor nach Anspruch 1, wobei die erste isolierende Zwischenschicht (218) ein Loch (229) aufweist, das zulässt, dass der erste Erfassungs-Teilabschnitt oder der Steuerungs-Teilabschnitt über das Loch an der ersten isolierenden Zwischenschicht freiliegt.

13. Trägheitskraft-Sensor nach einem der Ansprüche 1 bis 12, wobei die zweite isolierende Zwischenschicht (218b) mit der ersten isolierenden Zwischenschicht (218a) verbunden ist.

14. Trägheitskraft-Sensor nach Anspruch 1, wobei der Ansteuerungs-Teilabschnitt und der erste Erfassungs-Teilabschnitt jeweils enthalten:

eine untere Elektrode (228, 420), die sich an der Oberseite des flexiblen Teilabschnitts befindet;
eine piezoelektrische Schicht (220, 421), die sich an einer Oberseite der unteren Elektrode befindet, sowie
eine obere Elektrode (227, 422), die sich an einer Oberseite der piezoelektrischen Schicht befindet.

15. Trägheitskraft-Sensor nach Anspruch 14, wobei die piezoelektrische Schicht (227) eine Seitenfläche hat, die mit der ersten isolierenden Zwischenschicht bedeckt ist.

16. Trägheitskraft-Sensor nach Anspruch 1, der des Weiteren ein Lot (210, 410) umfasst, das mit dem flexiblen Teilabschnitt verbunden ist.

17. Trägheitskraft-Sensor nach Anspruch 16, wobei sich die erste isolierende Zwischenschicht nicht bis zu dem Lot erstreckt.

**Revendications**

1. Capteur de force d'inertie comprenant :

une base (202, 402),
une première électrode de connexion (215, 415a) disposée sur la base,
une section souple (205, 206 à 209, 251, 409) supportée par la base,
une section d'attaque (211, 411) qui est disposée sur la surface supérieure de la section souple et qui amène la section souple à vibrer,
une première section de détection (212, 412) qui est disposée sur la surface supérieure de la section souple et qui détecte un déplacement de la section souple,
une première couche d'isolement de couche intermédiaire (218, 218a) disposée sur la surface supérieure de l'une de la section d'attaque et de la première section de détection, et
un premier câblage (216, 217) reliant électriquement une autre de la section d'attaque et de la première section de détection à la première électrode de connexion au travers de la surface supérieure de la première couche d'isolement de couche intermédiaire,
le capteur de force d'inertie étant **caractérisé en ce qu'**il comprend en outre :

une deuxième section de détection (213, 413) qui est disposée sur la surface supérieure de la section souple et qui détecte le déplacement de la section souple,
une deuxième couche d'isolement de couche intermédiaire (218b, 218c) disposée sur la surface supérieure de la deuxième section de détection,
une deuxième électrode de connexion (215, 415b) disposée sur la base, et
un deuxième câblage reliant électriquement l'une de la première section de détection et de la section d'attaque à la deuxième électrode de connexion au travers de la surface supérieure de la deuxième couche d'isolement de couche intermédiaire,

dans lequel le premier câblage relie électriquement l'autre de la première section de détection et de la section d'attaque à la première électrode de connexion au travers de la surface supérieure de la deuxième couche d'isolement de couche intermédiaire, et

dans lequel au moins l'une de la première électrode de connexion (415a) et de la deuxième électrode de connexion (415b) inclut :

> une première couche piézoélectrique (421),
> une première couche isolante (423) recouvrant une partie de la première couche piézoélectrique, et
> une première couche d'électrode (422) disposée sur la première couche isolante.

**2.** Capteur de force d'inertie selon la revendication 1, comprenant en outre :

> une troisième section de détection (214, 414) qui est disposée sur la surface supérieure de la section souple et qui détecte le déplacement de la section souple,
> une troisième couche d'isolement de couche intermédiaire (218c) disposée sur la surface supérieure de la troisième section de détection,
> une troisième électrode de connexion disposée sur la base, et
> un troisième câblage reliant électriquement la deuxième section de détection à la troisième électrode de connexion au travers de la surface supérieure de la troisième couche d'isolement de couche intermédiaire.

**3.** Capteur de force d'inertie selon la revendication 2, dans lequel le premier câblage relie électriquement l'autre de la première section de détection et de la section d'attaque à la première électrode de connexion au travers de la surface supérieure de la première couche d'isolement de couche intermédiaire, de la surface supérieure de la deuxième couche d'isolement de couche intermédiaire et de la surface supérieure de la troisième couche d'isolement de couche intermédiaire, et

dans lequel le deuxième câblage relie électriquement la première de la première section de détection et de la section d'attaque à la deuxième électrode de connexion au travers de la surface supérieure de la deuxième couche d'isolement de couche intermédiaire et de la surface supérieure de la troisième couche d'isolement de couche intermédiaire.

**4.** Capteur de force d'inertie selon la revendication 2 ou la revendication 3, dans lequel la première couche d'isolement de couche intermédiaire, la deuxième couche d'isolement de couche intermédiaire et la troisième couche d'isolement de couche intermédiaire sont reliées l'une à l'autre.

**5.** Capteur de force d'inertie selon la revendication 1, dans lequel la première section de détection et la deuxième section de détection présentent des tailles différentes l'une de l'autre.

**6.** Capteur de force d'inertie selon la revendication 1, dans lequel chacune de la première section de détection et de la deuxième section de détection inclut :

> une seconde couche piézoélectrique (220, 421), et
> une seconde couche d'électrode (227, 422) disposée sur la seconde couche piézoélectrique.

**7.** Capteur de force d'inertie selon la revendication 1, comprenant en outre :

> une troisième section de détection qui est disposée sur la section souple et qui détecte le déplacement de la section souple, et
> une troisième électrode de connexion qui est disposée sur la base et qui est reliée électriquement à la troisième section de détection.

**8.** Capteur de force d'inertie selon la revendication 1, dans lequel la section souple inclut :

> une section formant poutre (205), et
> un bras (206 à 202) relié à la section formant poutre.

**9.** Capteur de force d'inertie selon la revendication 1, comprenant en outre :

une deuxième électrode de connexion disposée sur la base,

une troisième couche d'isolement de couche intermédiaire disposée sur la surface supérieure du premier câblage, et

un deuxième câblage reliant électriquement la première de la première section de détection et de la section d'attaque à la deuxième électrode de connexion au travers de la surface supérieure de la troisième couche d'isolement de couche intermédiaire.

10. Capteur de force d'inertie selon la revendication 1, comprenant en outre : une couche métallique (231) disposée dans la troisième couche d'isolement de couche intermédiaire.

11. Capteur de force d'inertie selon la revendication 10, dans lequel la couche métallique est configurée pour être reliée à un potentiel de référence.

12. Capteur de force d'inertie selon la revendication 1, dans lequel la première couche isolement de couche intermédiaire (218) possède un trou (229) permettant d'exposer la première de la première section de détection et de la section d'attaque à partir de la première couche isolement de couche intermédiaire au travers du trou.

13. Capteur de force d'inertie selon l'une quelconque des revendications 1 à 12, dans lequel la deuxième couche d'isolement de couche intermédiaire (218b) est reliée à la première couche d'isolement de couche intermédiaire (218a).

14. Capteur de force d'inertie selon la revendication 1, dans lequel chacune de la section d'attaque et de la première section de détection inclut :

une électrode inférieure (228, 420) disposée sur la surface supérieure de la section souple,

une couche piézoélectrique (220, 421) disposée sur la surface supérieure de l'électrode inférieure, et

une électrode supérieure (227, 422) disposée sur la surface supérieure de la couche piézoélectrique.

15. Capteur de force d'inertie selon la revendication 14, dans lequel la couche piézoélectrique (227) comporte une surface latérale recouverte de la première couche d'isolement de couche intermédiaire.

16. Capteur de force d'inertie selon la revendication 1, comprenant en outre un plomb (210, 410) relié à la section.

17. Capteur de force d'inertie selon la revendication 16, dans lequel la première couche d'isolement de couche intermédiaire ne s'étend pas jusqu'au plomb.

# FIG. 1

# FIG. 2

FIG. 3

## FIG. 4

## FIG. 5

# FIG. 6

# FIG. 7A

# FIG. 7B

# FIG. 8A

201c

216 217 216 217

218b
(218)

231

218a
(218)

213

205

# FIG. 8B

201d

217 216 217

218c
(218)

218b
(218)

231

218a
(218)

213

205

## FIG. 8C

# FIG. 9

# FIG. 10A

## FIG. 10B

## FIG. 10C

# FIG. 11

# FIG. 12A

# FIG. 12B

# FIG. 13A

```
                    ┌─────────────────────────┐
                    │          Start          │
                    └─────────────────────────┘
                                 ↓
S201 ─┤  Form Lower Electrode Layer  │
                                 ↓
S202 ─┤   Form Piezoelectric Layer   │
                                 ↓
S203 ─┤  Form Upper Electrode Layer  │          ┌──────────────────────────┐
                                 ↓              │ Draw Lower Electrode Layer │ ─S2051
S204 ─┤      Process Electrodes       │         └──────────────────────────┘
                                 ↓                           ↓
S205 ─┤        Form Wirings           │         ┌────────────────────────────────┐
                                 ↓              │ Form Interlayer Insulating Layer │ ─S2052
S206 ─┤          Polarize             │         └────────────────────────────────┘
                                 ↓                           ↓
S207 ─┤     Pattern Base Material     │         ┌──────────────────────────┐
                                 ↓              │      For Contact Hole      │ ─S2053
S208 ─┤     Process Base Material     │         └──────────────────────────┘
                                 ↓                           ↓
S209 ─┤        Back-Grinding          │         ┌──────────────────────────┐
                                 ↓              │        Wiring Layer        │ ─S2054
S210 ─┤           Dicing             │          └──────────────────────────┘
                                 ↓                           ↓
S211 ─┤    Inspect Chacteristics      │         ┌──────────────────────────┐
                                                │       Process Wirings      │ ─S2055
                                                └──────────────────────────┘
```

# FIG. 13B

```
            ┌─────────────────────────────┐
            │            Start            │
            └─────────────────────────────┘
                           │
                           ▼
S201 ──┤    Form Lower Electrode Layer    │
                           │
                           ▼
S202 ──┤     Form Piezoelectric Layer     │
                           │
                           ▼
S203 ──┤    Form Upper Electrode Layer    │
                           │
                           ▼
S204 ──┤        Process Electrodes        │
                           │
                           │
                           ▼
S206 ──┤            Polarize             │
                           │
                           ▼
S207 ──┤      Pattern Base Material       │
                           │
                           ▼
S208 ──┤      Process Base Material       │
                           │
                           ▼
S209 ──┤          Back-Grinding           │
                           │
                           ▼
S210 ──┤             Dicing              │
                           │
                           ▼
S211 ──┤      Inspect Chacteristics       │
```

## FIG. 14A

## FIG. 14D

## FIG. 14B

## FIG. 14E

## FIG. 14C

## FIG. 14F

# FIG. 15

# FIG. 16A

# FIG. 16B

# FIG. 17

# FIG. 18A

# FIG. 18B

# FIG. 19

# FIG. 20

# FIG. 21A

```
                  ┌─────────────────────────┐
                  │          Start          │
                  └─────────────────────────┘
                               │
                               ▼
S401 ─┐  ┌─────────────────────────┐
      └──│  Form Lower Electrode Layer │
         └─────────────────────────┘                    ┌─────────────────────────┐
                               │                        │    Polyimide Coating    │─S4021
S402 ─┐  ┌─────────────────────────┐                    └─────────────────────────┘
      └──│   Form Piezoelectric Layer │                             │
         └─────────────────────────┘                                ▼
                               │                        ┌─────────────────────────┐
                               │                        │        Patterning        │─S4022
                               │                        │ (Exposing and Developing) │
                               │                        └─────────────────────────┘
S403 ─┐  ┌─────────────────────────┐                             │
      └──│  Form Upper Electrode Layer │                          ▼
         └─────────────────────────┘                    ┌─────────────────────────┐
                               │                        │          Cure           │─S4023
S404 ─┐  ┌─────────────────────────┐                    └─────────────────────────┘
      └──│     Process Electrodes     │
         └─────────────────────────┘
                               │
S405 ─┐  ┌─────────────────────────┐
      └──│         Polarize          │
         └─────────────────────────┘
                               │
S406 ─┐  ┌─────────────────────────┐
      └──│    Pattern Base Material   │
         └─────────────────────────┘
                               │
S407 ─┐  ┌─────────────────────────┐
      └──│    Pattern Base Material   │
         └─────────────────────────┘
                               │
S408 ─┐  ┌─────────────────────────┐
      └──│       Back-Grinding       │
         └─────────────────────────┘
                               │
S409 ─┐  ┌─────────────────────────┐
      └──│          Dicing          │
         └─────────────────────────┘
                               │
S410 ─┐  ┌─────────────────────────┐
      └──│   Inspect Chacteristics   │
         └─────────────────────────┘
```

# FIG. 21B

```
              ┌─────────────────────────┐
              │          Start          │
              └─────────────────────────┘
                           │
                           ▼
S401 ─┐ ┌─────────────────────────┐
      └─│  Form Lower Electrode Layer │
        └─────────────────────────┘
                           │
                           ▼
S402 ─┐ ┌─────────────────────────┐
      └─│   Form Piezoelectric Layer  │
        └─────────────────────────┘
                           │
                           ▼
S403 ─┐ ┌─────────────────────────┐
      └─│  Form Upper Electrode Layer │
        └─────────────────────────┘
                           │
                           ▼
S404 ─┐ ┌─────────────────────────┐
      └─│      Process Electrodes     │
        └─────────────────────────┘
                           │
                           ▼
S405 ─┐ ┌─────────────────────────┐
      └─│          Polarize          │
        └─────────────────────────┘
                           │
                           ▼
S406 ─┐ ┌─────────────────────────┐
      └─│    Pattern Base Material    │
        └─────────────────────────┘
                           │
                           ▼
S407 ─┐ ┌─────────────────────────┐
      └─│    Process Base Material    │
        └─────────────────────────┘
                           │
                           ▼
S408 ─┐ ┌─────────────────────────┐
      └─│       Back-Grinding        │
        └─────────────────────────┘
                           │
                           ▼
S409 ─┐ ┌─────────────────────────┐
      └─│           Dicing           │
        └─────────────────────────┘
                           │
                           ▼
S410 ─┐ ┌─────────────────────────┐
      └─│    Inspect Chacteristics    │
        └─────────────────────────┘
```

# FIG. 22

# FIG. 23

# FIG. 24

FIG. 25

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009041502 A1
- WO 2011093077 A